(19) Europäisches Patentamt
European Patent Office
Office européen des brevets

(11) **EP 4 266 075 A1**

(12) **EUROPEAN PATENT APPLICATION**

(43) Date of publication:
**25.10.2023 Bulletin 2023/43**

(21) Application number: **22169601.6**

(22) Date of filing: **22.04.2022**

(51) International Patent Classification (IPC):
**G01R 33/56** *(2006.01)*    **G01R 33/561** *(2006.01)*

(52) Cooperative Patent Classification (CPC):
**G01R 33/561; G01R 33/5608**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Ecole Polytechnique Fédérale de Lausanne (EPFL)**
**EPFL-TTO**
**1015 Lausanne (CH)**

(72) Inventors:
• **Widmaier, Mark**
  **1020 Renens (CH)**
• **Lim, Songi**
  **1007 Lausanne (CH)**
• **Xin, Lijing**
  **1028 Préverenges (CH)**

(74) Representative: **Schneiter, Sorin**
**Léman IP**
**Avenue de Riond-Bosson 3**
**1110 Morges (CH)**

Remarks:
Claims 16-20 are deemed to be abandoned due to non-payment of the claims fees (Rule 45(3) EPC).

(54) **HIGH-DIMENSIONAL PARAMETER DETERMINATION BASED ON MR FINGERPRINTING MEASUREMENTS**

(57) The present invention concerns a method for determining an estimated value for different parameters on the basis of one or more acquired signals obtained during a Magnetic Resonance Fingerprinting measurement. The method includes an iterative approach, where some parameters are treated as free parameters and the values of other parameters are provisionally set to an assumed value for creating a dictionary. In a subsequent iterative step, the values obtained by matching for previously free parameters are used to set these parameters, and previously set parameters are treated as free parameters. In some embodiments, the accuracy of the estimated is improved by a functional or correlational part, in which a correlation of parameters with a global parameter is used.

Figure 3B

## Description

### Technical Field

The present invention generally relates to the field of signal processing, in particular signals obtained from Magnetic Resonance (MR) Fingerprinting measurements. More specifically, the invention relates to a method for determining parameters based on MR fingerprinting measurements.

### Background Art and Problems Solved by the Invention

Magnetic Resonance Fingerprinting (MRF) has been introduced by Dan Ma et al, Nature, 2013, 495(7440): 187-192 as a new approach to data acquisition, post-processing and visualization in Magnetic Resonance (MR) techniques. As described in this paper, traditional MR techniques such as NMR spectroscopy and MR Imaging (MRI) are often restricted to determining qualitative, non-fully quantitative outcomes, whereas, when quantitative data is obtained, the latter are typically limited to a single parameter, are sensitive to system imperfections and require significant scan time.

MRF, also disclosed in various patent documents such as US 10,416,259, US10,492,710 and US 2015/0301138, takes a different approach in that it uses an acquisition that causes the signals from different materials or tissues to have a unique signal evolution or "fingerprint", that is simultaneously a function of the multiple material properties under investigation. The processing after acquisition comprises a pattern recognition algorithm to match the fingerprints to a predefined dictionary of predicted signal evolutions. The outcome of the matching can then be translated into quantitative maps of the MR parameters under investigation. As indicated by Dan Ma et al. 2013, MRF has the potential to quantitatively examine many MR parameters simultaneously that could detect important but complex changes across a large number of parameters simultaneously.

For interpreting the outcome of an MRF measurement, a dictionary of signal evolutions is created with the aid of a model, basically based on the Bloch or Bloch-McConnel equations, which calculate the nuclear magnetization as a function of time when relaxation times $T_1$ and $T_2$ are present (F. Bloch, Nuclear Induction, Phys Rev 1946; 70:460-474,1946).

The model is constructed to take into account the different parameters that have an impact on the signal evolution, based on a particular signal generation regime, which is generally a particular radio frequency (RF) field that is switched on and off to produce an RF pulse train (or pulse sequence) suitable to generate a MR signal that can be conveniently interpreted. Parameters of the pulse sequence are the carrier frequency, the number of RF pulses, flip angles and phase of RF pulses, pulse profile, gradients, the repetition time (TR), the echo time (TE), the acquisition time, for example. An exemplary RF pulse train that has been used in MRF is balanced steady-state free precession (bSSFP), for example.

Although MRF has the potential to quantitatively examine many MR parameters simultaneously, the different parameters have a highly cumulative impact on the number of modelled signal evolutions when creating the dictionary. With an increasing number of parameters, the dictionary takes more time to create and requires more electronic storage space. Furthermore, the matching process, where an acquired signal is matched among the signal evolutions in the dictionary, is more time consuming, too. To make an example, if a particular setting involves six parameters that have an impact on a signal evolution, with each parameter being represented by 30 different values for creating the dictionary, one obtains $30^6$ signal evolutions, in other words about 800 million signal evolutions. Assuming 0.015 seconds per signal evolution, the creation of the dictionary takes about 127 days using a dedicated server equipped with a 32 multi cores. In terms of memory, this approach requires a memory of 4.5 Petabyte, with non-compressed storing.

In other words, the potential of MRF as a new multi-parameter assessing approach is limited by the current post-processing approaches, in particular the requirement to use matching with a dictionary of signal evolutions, who take the multiple parameters into account.

Wang et al, 2017, NMR Biomed., vol. 30,12 (2017): 10.1002/nbm.3786. doi:10.1002/nbm.3786, disclose $^{31}$P Magnetic Resonance Fingerprinting for the rapid quantification of the creatine kinase reaction rate in vivo. Creatine kinase reversibly catalyses the conversion of phosphocreatine (PCr) to adenosine diphosphate from adenosine triphosphate (ATP), the latter being the "energy currency" of living cells, in particular in skeletal muscles, the myocardium and in the brain. By quantifying key components of the energy metabolism, the $^{31}$P MRF becomes a precious tool for in vivo studies. Alterations of ATP metabolic reactions could result in abnormal cellular function and have been reported in several psychological and metabolic disorders, such as the neuropathology of schizophrenia and trauma brain injury.

Wang et al (2017) report the quantification of the forward rate constant ($k_{CK}$) of ATP synthesis via Creatine Kinase (CK) in rat hindlimb. For creating the dictionary, four parameters, $k_f^{CK}$, $T_1^{PCr}$, $\omega^{PCr}$ ($f_0^{PCr}$) and $M_R^{PCr}$ were varied over their physiologically expected range. Five remaining parameters, which have an impact on the acquired signal evolution, $\omega^{\gamma ATP}$ ($f_0^{\gamma ATP}$), $T_2^{PCr}$, $T_2^{\gamma ATP}$, $T_1^{\gamma ATP}$, and LW (linewidth) were fixed to literature values or premeasurements, such that only the four first mentioned parameters were quantitatively assessed.

The above illustrates directly that the number of modelled signal evolutions in the dictionary, or more generally, the size of the dictionary, becomes a limiting factor to the practical applications of MRF, in particular in cases where a larger number of parameters is to be assessed. Already with four (4) parameters, the currently available approaches can become unpractical based on the calculation power of computers that are readily available today and depending on the complexity of the model.

It is an objective of the present invention to provide a new approach for efficient and accurate high-dimensional parameter estimation in magnetic resonance fingerprinting. It is in particular an objective to provide an approach practical to estimate three, four, five or more parameters in magnetic resonance fingerprinting. It is an objective to estimate these parameters in a comparatively fast manner while requiring comparatively less electronic storage space.

It is an objective of the invention to facilitate the exploitation of the total potential provided by techniques of MRF.

The present invention addresses the problems and objectives depicted above.

Further objectives and problems addressed by the present invention will become apparent from the description of the aspects and embodiments of the invention herein below.

## Summary of the Invention

The present inventors provide a method for determining an estimated value ($v_X^E$) of parameters ($p_X = [p_1, p_2 ..., p_N]$) that affect the evolution of a signal acquired during a Magnetic Resonance Fingerprinting (MRF) measurement.

Surprisingly, the inventors provide an iterative approach for determining an estimated value ($v_X^E$) of a plurality of parameters, wherein the number of signal evolutions in a dictionary is reduced by provisionally setting the values of some parameters to a set value and, in a later step, varying the values of a previously set parameter. As a consequence, the various parameters values used for creating the dictionary do not contribute exponentially, but partially additively to the dictionary. In the end, a dictionary having substantially fewer simulated signal evolutions can be used for assessing an acquired signal during matching. In an embodiment, the iterative approach is combined with a functional or correlational approach, involving the designation of a global parameter. Thanks to the correlational approach, final estimate values ($v_X^{E+}$; $v_G^{E+}$) for the parameters involved in the signal evolutions can be obtained.

In an aspect, the invention provides a method for providing an estimated value ($v_X^E$) for each of N different parameters ($p_X = [p_1, p_2 ..., p_N]$) that affect an acquired signal evolution obtained during a Magnetic Resonance Fingerprinting (MRF) measurement, wherein N is an integer of $\geq 3$, the method comprising: defining one, two or more of said N parameter as free parameters ($p_X^F$); defining one, two or more of the remaining parameters as non-free parameters and setting the values of each of the non-free parameters to a set parameter value ($v_X^S$); obtaining a dictionary of simulated signal evolutions by using values for said free parameters and said set parameter values ($v_X^S$); obtaining an estimated value ($v_X^E$) for said free parameters by matching a simulated signal evolution with said acquired signal, and, repeating the steps of obtaining a dictionary and obtaining an estimated value iteratively, wherein the value of one or more parameters, which were previously free parameters, are set to the estimated values ($v_X^E$) obtained by said matching, wherein one or more of said other parameters that were previously non-free parameters are defined as actual free parameters ($p_X^F$), and wherein repetition is conducted until an estimated value is obtained for all said parameters.

In an aspect, the invention provides computer readable programs and software and computer readable data carriers for conducting the methods of the invention.

In an aspect, the invention provides an apparatus, in particular an NMR (Nuclear Magnetic Resonance) apparatus configured to conduct the method of the invention.

In an aspect, the invention provides a diagnostic method comprising the method of the invention. The diagnostic method may make use of the values of parameters for comparing the values with reference values and determining is a particular condition, for example a disease, such as cancer, is present.

Further aspects and preferred embodiments of the invention are defined herein below and in the appended claims. Further features and advantages of the invention will become apparent to the skilled person from the description of the preferred embodiments given below.

## Brief Description of the Drawings

**Figures 1A** and **1B** illustrates an exemplary pulse sequence and signal acquisition pattern used in accordance with an embodiment of the invention.

**Figure 1C** shows a $^{31}$P NMR (Nuclear Magnetic Resonance) spectrum of the human brain to demonstrate the inversion profiles of the two asymmetric inversion pulses.

**Figure 2A** and **2B** show $^{31}$P NMR group spectra and signal evolutions, respectively, based on MRF in accordance with an embodiment of the invention.

**Figures 3A** and **3B** schematically illustrate the iterative approach in accordance with embodiments of the invention, in a general manner (Fig. 3A) and applied to parameters involved in $^{31}$P MR Fingerprinting measurements (Fig. 3B).

**Figure 4** shows simulated matching error (ME) of each free parameter, according to experiments conducted in accordance with an embodiment of the invention. ME estimation introduced on free parameter by ranging each ground truth value of (a) $k_{CK}$, (b) $T_1^{PCr}$, (c) $T_1^{ATP}$, (d) $T_2^{PCr}$, (e) $T_2^{ATP}$ and (f) $C_r$, and fixing the other parameters to their initial ground truth.

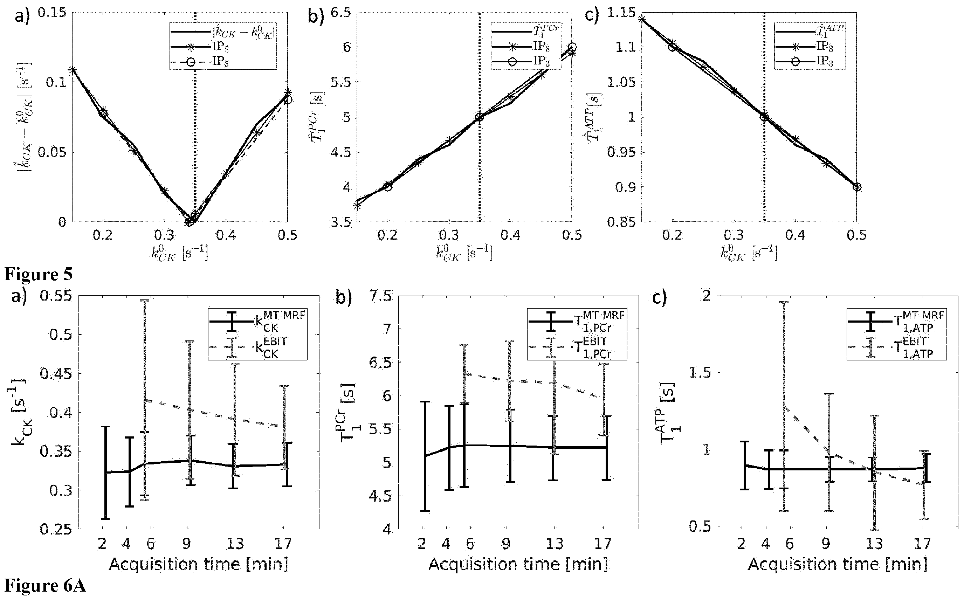

**Figure 5** shows graphs illustrating the determination of final estimated values ($v_G^{E+}$, $v_X^{E+}$) for parameters by linear approximation and finding the minimum value of the cost function, in accordance with an embodiment. In panel a), the final estimated value of the global parameter $k_{CK}$ ($k_{CK}^{E+}$) is where the cost function is minimal (here zero). The functions of the estimated values of other parameters, $T_{1(Pcr)}$ and $T_{1(\gamma ATP)}$ ($T_1^E$ and $T_{1(\gamma ATP)}^E$ over $k_{CK}^{F.Y}$) are approximated by linear function. A small bias is introduced due to the non-linearity.

**Figures 6A** and **6B** show the values of the $^{31}$P related parameter values ($k_{CK}$, $T_{1(PCr)}$ and $T_{1(\gamma ATP)}$, as applicable) obtained in accordance with an embodiment of the invention in comparison with values obtained by the gold standard EBIT (Efficient Band Inversion Transfer) method. Mean and STD (Standard Deviation) of estimated parameters values are compared for $k_{CK}$, $T_{1(PCr)}$ and $T_{1(\gamma ATP)}$ over the acquisition time in panels a)-c). Mean and STD of CV (Coefficient of Variation) are shown in panels d)-f).

Hereinafter, preferred embodiments of the device of the invention are described, in order to illustrate the invention, without any intention to limit the scope of the present invention.

## Detailed Description of the Preferred Embodiments

The present invention relates to a method for obtaining estimated values of parameters that affect the signal evolution acquired in an MRF measurement. The parameters may be known or believed to affect the signal evolution. The parameters include at least some but preferably as many as possible, preferably all parameters that in some way influence and/or have an impact on the acquired signal evolution and are not directly measurable. Such parameters are also known in the literature as or "hidden" parameters.

Parameters that are encompassed by the present invention may be selected from the group consisting of: relaxation parameters, such as $T_1$ (longitudinal relaxation time of relaxation in dimension z), $T_2$ (transversal relaxation time of relaxation in plane xy, true $T_2$), and $T_2^*$ ("effective" $T_2$, with the contribution of magnetic field inhomogeneities); chemical exchange rates involving nuclei that exhibit nuclear magnetic resonance, such as $k_{CK}$ (the chemical exchange rate of the phosphate between ATP and PCr (phosphocreatine)); concentration ratios of molecules comprising nuclei that exhibit nuclear magnetic resonance, for example $C_r$ (the concentration ratio between PCr and $\gamma$ATP in $^{31}$P MRF ([PCr]/[yATP])); parameters related to the magnetic fields ($B_1$, $B_0$), such as $B_1^+$ (transmitted $B_1$ field inhomogeneities), $B_1^-$ (received field sensitivity), $f_{OFF}$ (the mean off-resonance of the $B_0$ distribution), and $f_{B1}$.

For the purpose of the present specification, different parameters are symbolized by px, wherein X is an integer in the range of 2 to N, such that N determines the number of parameters that are included and/or considered as free parameters in the method of the invention (px = [$p_1$, $p_2$ ..., $p_N$]). For example, in the application of $^{31}$P-MRF, $p_1$ may be $T_{1(\gamma ATP)}$, $p_2$ may be $T_{2(\gamma ATP)}$, and so forth. The estimated value of the parameter to be obtained by the method of the invention is symbolized as $v_X^E$. The assumed value of the parameter, corresponding to the value that the parameter is considered to be the true value on the basis of previously conducted experiments or literature reports, is symbolized as $v_X^A$. The set parameter value, $v_X^S$, is preferably the set value used for a non-free parameter, and is preferably selected from $v_X^A$ or, if available, is $v_X^E$.

N may be an integer of from 2 to 50 preferably 3 to 20, more preferably 3 to 10 and most preferably 4 to 8. In a preferred embodiment, N is 3 or larger, 4 or larger, preferably 5 or larger, more preferably 6 or larger and most preferably 7 or larger.

The parameters the value of which is to be estimated may also be referred to as "free parameters". Free parameters may be abbreviated by $p_X^F$ in the present specification, where px denotes a particular parameter out of the N different parameter, and the suffix F indicates that the parameter is a free parameter. Other parameters, the value of which is known or for which a value can be assumed or estimated are referred to as "set parameters" ($p_X^S$). In accordance with the invention, a particular parameter, e.g. $T_1^{\gamma ATP}$ may be sequentially considered as a free parameter or a set parameter. Furthermore, the term "non-free parameter" may be used in this specification for referring to a parameter the value of which has been set to a set value $v_X^S$ during part of the method, for example during an iteration.

In MRF, a mathematical model is used to create a dictionary of simulated signal evolutions. Such mathematical models generally include the Bloch or Bloch-McConnel equations and have been reported and disclosed in the art. One, two or more pool models may be used. For estimating the values of free parameters, a matching method or step is generally performed, in which an acquired signal evolution is compared with simulated signal evolutions of the dictionary, and the best match is used to obtain the estimated values of the free parameters.

In an embodiment, the invention comprises providing a model suitable to simulate a signal evolution obtained by exposing a sample or an individual to an input defined by said MR Fingerprinting measurement, wherein said model takes into account said N parameters affecting said signal evolution. The model is preferably provided specifically depending on a particular MRF experimental setting, including the signal acquisition pattern, and the involved parameters. Such models have been disclosed in the literature and an exemplary model is disclosed in the experimental setting disclosed herein below.

For creating the dictionary, free parameters are given a plurality of successive values encompassed by a range which is assumed to encompass the "true value" of the parameter, wherein the true value is the value that the particular parameter has in the sample that is exposed to the MRF experiment when the signal is acquired. As will be discussed in more detail below, the number of free parameters, but also the number of successive values of the free parameters, determine the number of simulated signal evolutions and thus the size of the dictionary. The size of the dictionary, in turn, affects the electronic storage space and calculation power needed to estimate the parameter values. In the end, the size of the dictionary determines the feasibility of the method on the basis of generally available computers or, put in other words, the price of the computers needed to conduct the method within a useful time.

The number ($Zp_X^F$) of successive values of the free parameters is not a fixed value, but is generally determined in dependence of considerations of the person skilled in the art, which considerations include the parameter in question, the extent of the range within which the value of the parameter is expected to lie, and others.

For giving a specific example based on the experiments conducted in accordance with an embodiment, the 101 successive values 0.5, 0.51, 0.52, 0.53, ..., 1.49, 1.50, were attributed to the parameter $f_{B1}$, thus defining an assumed value range of 0.5-1.5. In this example, the different successive values are separated by constant gaps from their closest neighbour or neighbours (i.e. 0.01 from one successive value to one or both closest neighboring values). In other embodiments, the gaps between successive values need not be constant, but may vary, and may, for example, be smaller in the proximity of the assumed value of the parameter.

For the purpose of the present specification, the number (integer) of successive values of a free parameter $p_X^F$ is symbolized by Z, or, more specifically, in relation to the particular parameter: $Z(p_X^F)$. The successive values are symbolized as $v_X^{F.1}$, $v_X^{F.2}$, ... , $v_X^{F.Z}$. The symbol $v_X^{F.Y}$, where Y is an integer given successively to the different values (Y = [1, .... $Z(p_X^F)$]), may be used in this specification to refer to any one of said successive values in particular or to all of them.

The assumed value range $v_X^{F.1}$ - $v_X^{F.Z}$ is preferably selected so that so as to encompass one or more selected from: an assumed value ($v_X^A$), said estimated value ($v_X^E$) to be determined of said particular parameter px and/or the true value of the parameter.

One limitation of MRF is linked to the size of the dictionary used for the matching procedure. The more "free" parameters are incorporated in the model for creating the dictionary, the larger the dictionary, as the number of successive values of a free parameters generally multiplies with the numbers of successive values of the other free parameters. As a consequence, it is generally necessary to limit the number of free parameters to currently about four (4). With larger numbers of free parameters, the size of dictionary becomes so large that it is no longer possible to obtain estimated values within sufficiently short (reasonable) time limits.

On way of reducing the number of free parameters is using assumed or set values for many of the parameters that are known to contribute to the signal evolution acquired in an MRF experiment. This solution, however, is not possible or satisfactory in all cases, as some parameters may not be taken into account appropriately. In particular, the estimated values obtained for the free parameters may be biased by the error introduced when setting the value of a parameter to an assumed value that is different from the parameter's true value. Consequently, the entire outcome of the MRF measurement may be biased by error.

The present inventors surprisingly provide an iterative approach, which makes it possible to reduce the size of the dictionary and thus to include more free parameters in the model.

In the iterative approach, only some parameters are treated as free parameters ($p_X^F$), while for the values of other parameters ($p_X^S$) a provisional set value, for example, an assumed value ($v_X^A$), is used. In a subsequent step of the iterative method, previously set parameters ($p_X^S$) are treated as free parameters, while previously free parameters are treated as set parameters. In this case, the value of previously free parameters is preferably set to an estimated value ($v_X^E$) obtained by matching when considering the parameter as a free parameter. The iterative approach is preferably repeated until an estimated value is obtained for all parameters. It is noted that for some parameters, a estimated value can be obtained by calculation from the data associated with other, previously free parameters. The calculated parameters need not be treated as free parameters but may be included in the total number of parameters considered by the model. In this manner, the various parameters do not contribute in an exponential manner to the number of dictionaries, as a reduced number of simulated signal evolutions is created.

In an embodiment, the invention further provides a correlative and/or functional approach, in which a final estimated value ($v_X^{E+}$) is obtained for each parameter, as discussed in more detail elsewhere in this specification.

In an embodiment, the invention comprises splitting said parameters in different groups of parameters and defining the parameters of a group as free parameters ($p_X^F$) and setting the parameters values of the other groups to a set parameter value ($v_X^S$). If an estimated value is not (yet) available, an assumed value ($v_A^X$) is used, which may be selected from likely values, literature values or previously reported and/or previously determined values for the corresponding parameter, for example. When an estimated value has already been obtained, the assumed value is replaced by the estimated value. Both, the assumed and the estimated values may thus be used as set values (either $V_X^A$ or $V_X^E = v_X^S$). This may apply to one iteration or to part of an iteration, for example, in the method of the invention.

Preferably, two or more (n) groups of parameters are provided, wherein each group comprises one or more parameters. If n = N, the group number is same as the number of parameters such that each parameter is treated separately in an iterative manner. If n=1 there is only one group and no iterative manner would be necessary. In an embodiment, the number of groups (n) is two or larger and < N. Preferably, n is selected from 2, 3, 4, 5, 6 and from larger integers. Preferably, n is an integer that is larger than or equal to N/5, preferably N/3, more preferably N/2, and most preferably N. It is noted that the definition of groups may not need to be a purposeful step of determining particular groups, but reflects simply the way the method is conducted by iteration. The different groups are thus preferably the subject of different and/or separate iterations of the method.

The invention is preferably not limited by how the parameters are grouped. In some embodiments, parameters are grouped by the parameter type. For example, a group may comprise relaxation parameters, another group may comprise parameters related to the magnetic fields ($B_0$, $B_1$) and inhomogeneities thereof, a group may comprise chemical exchange rates, and a group may comprise concentration ratios, for example. The aforementioned exemplary groups may be combined to form fewer groups. For example, relaxation parameters and concentration ratios of compounds associated with these relaxation parameters may be provided in one group.

In an embodiment, the method of the invention comprises defining one, two or more free parameters ($p_X^F$) amongst said N parameters and defining a plurality of $Z(p_X^F)$ successive values ($v_X^{F.Y} = v_X^{F.1}$, $v_X^{F.2}$, ... , $v_X^{F.Z}$; Y = [1, .... $Z(p_X^F)$]) of an assumed value range ($v_X^{F.1}$ - $v_X^{F.Z}$) independently for each of said free parameters, said assumed value range being preferably selected so as to encompass an assumed value ($v_X^A$), said estimated value ($v_X^E$) to be determined and/or a true value of said parameter, wherein Z is an integer $\geq$ 2 determined independently for each of said free parameter ($px^F$). Preferably, an assumed value ($v_X^A$) is for the remaining parameters, said remaining parameters being set parameters ($p_X^S$).

In an embodiment, Z is an integer of 2-1024, preferably 4-512, more preferably 8-256, and most preferably 16-64. For example, Z is an integer of 3-40. It is noted that Z is determined for each parameter independently.

In an embodiment, the method of the invention comprises obtaining a dictionary of simulated signal evolutions by using values for said free parameters and said set parameter values ($v_X^S$). For producing said dictionary, said plurality of successive values ($v_X^{F.Y}$) of said free parameters and said assumed set parameter values ($v_X^S$) are used so as to take into account said N parameters.

Preferably, for the free parameters ($p_X^F$), at least one simulated signal evolution is created for each of said plurality of successive parameter values ($v_X^{F.Y}$). For the other (non-free) parameters, the set parameter values ($v_X^S$), or, if already obtained in the method of the invention, an estimated value ($v_X^E$) is preferably used.

In an embodiment, the method of the invention comprises obtaining an estimated value ($v_X^E$) for a free parameter by matching a simulated signal evolution with said acquired signal. In an embodiment, the matching process comprises:

- matching an acquired signal evolution with said simulated signal evolutions of said dictionary,
- selecting a best match between said acquired signal and said simulated signal evolutions of said dictionary, and,
- determining an estimated value ($v_X^E$) for said free parameters ($p_X^F$), wherein said estimated value ($v_X^E$) is the value of the free parameter ($p_X^{F.Y}$) used for the simulated signal evolution corresponding to said best match.

The matching between acquired and simulated signal evolutions may be conducted by algorithms that are available and which include template matching, pattern matching, or other matching and comparing processes, for example using vector-dot product calculation. The criteria for determining the "best match" depend on the algorithm used when comparing signal evolutions. A "best match" may be seen as a (simulated) signal evolution that most closely resembles another (the acquired) signal evolution.

Preferably, once a best match between an acquired signal evolution and a simulated signal evolution is found, the particular value ($v_X^{F.Y}$) among the successive values ($v_X^{F.1}$-$v_X^{F.Z}$) of the free parameter that was used to create the matched simulated signal evolution is said estimated value $v_X^E$.

Further regarding the acquired signal used for matching, the invention encompasses that an extract of an acquired signal is used when determining an estimated value of a particular parameter, wherein the extract is selected in dependence of the parameter.

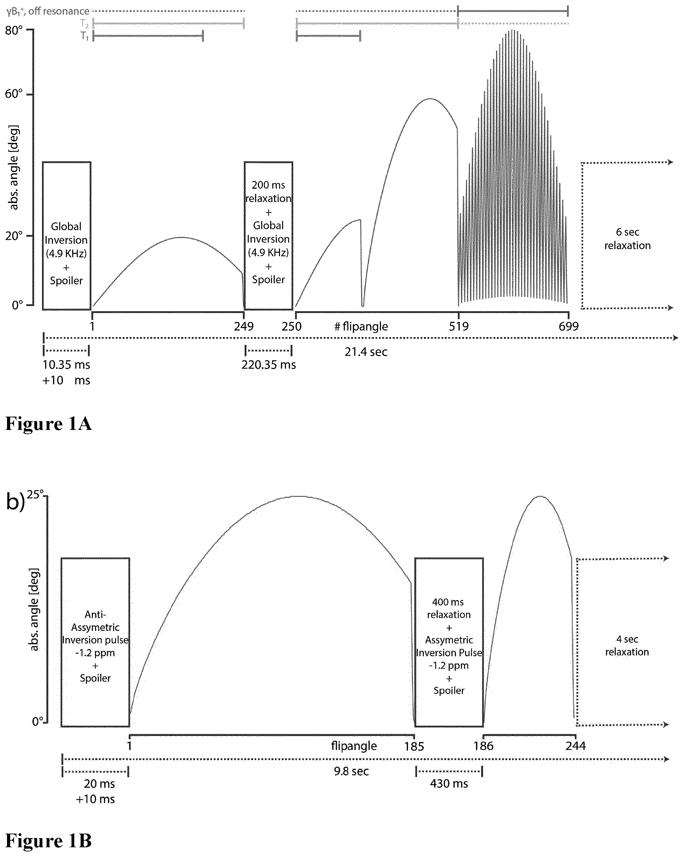

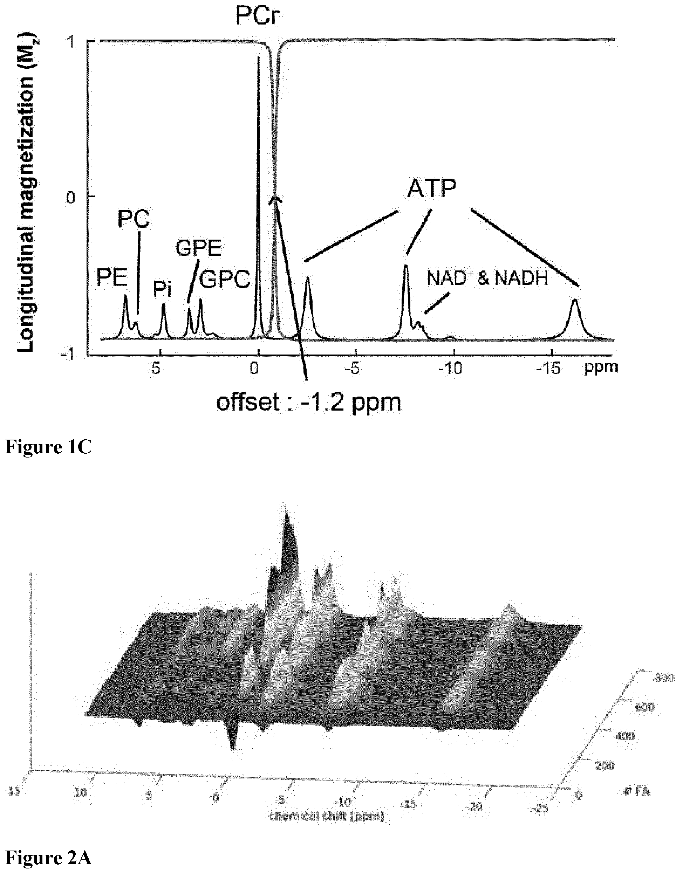

The invention also encompasses adjusting the signal generation regime (see Background of the Invention) and thus the acquired signal (or part thereof) for optimizing the matching with that particular parameter. Such procedures are generally known and are also illustrated in Figs 1A and 1B as described in the example section below. In accordance with the invention, the expression "acquired signal evolution" is not necessarily intended to mean "a single, continuous signal evolution used for matching all parameters".

In an embodiment, the steps of defining one or more free parameters ($p_X^F$), using set parameter value for other parameters, obtaining a dictionary, and matching, are repeated while using said estimated value ($V_X^E$) as a set value ($V_X^S$) for at least one of said previously free parameters and selecting one or more actual free parameters among the previously set parameters.

If parameters are grouped, the same principle applies generally to an entire group of parameters, i.e. the parameters of a group comprising previously set parameters are considered as free parameters, and one or more group with parameters that were previously considered as free parameters are considered as set parameters and are given the estimated values. Preferably, the method and/or the iterations are repeated until an estimated value is obtained for all parameters. If a group comprises two or more (e.g. $\Omega$) free parameters, a simulated signal evolution is created for each successive value of a first free parameter in combination with each successive value of the second and in combination with each successive value of each successive value up to the $\Omega^{th}$ free parameter. In a group containing one or more parameters that can be obtained by calculation from data that was previously generated in the iteration, no additional signal evolutions are modelled.

In an embodiment, defining said free and non-free parameters comprises:

a) splitting said N parameters $p_1$-$p_N$ in n groups, such that each group contains one or more different parameters;
b) selecting one or more group of said n groups, wherein the parameters in that one group are free parameters ($p_X^F$) and the estimated values ($v_X^E$) of at least one of said free parameters is to be determined by matching with simulated signal evolutions, as described elsewhere in this specification.

Optionally, repeating the steps of obtaining said dictionaries and obtaining an estimated value iteratively comprises: c) selecting another group of said n groups, wherein said other group comprises parameters for which an estimated parameter value ($v_X^E$) has not yet been determined. Generally, the parameters of said other group are defined as actual free parameters ($p_X^F$), and estimated values ($v_X^E$) for the actual free parameters are obtained by matching with simulated signal evolutions. In some cases, it may be possible to obtain an estimated value of the parameter in the other group by calculation from information concerning previously free parameters, so that the parameter(s) in that group does not need to be defined as a free parameter. In this case $v_X^E = v_X^C$.

In an embodiment, setting the value of one, two or more parameters to a set parameter value ($v_X^S$) comprises:

(i) in as far as available, using an estimated value ($v_X^E$), obtained previously by matching, or calculation, preferably as described elsewhere in this specification,
(ii) in as far as an estimated value ($v_X^E$) under (i) is not available, using an assumed value ($v_X^A$) of the corresponding parameter, which assumed value is preferably selected as defined above, e.g., from likely values, literature values, etc., and,
(iii) if the parameter is a global parameter ($p_G$), setting the value to a corresponding, predetermined successive start value ($v_G^{S.T}$) of said global parameter.

It is noted that (iii) only applies in cases where a global parameter as described elsewhere is used.

The estimated value ($v_X^E$) obtained previously may be an estimated value obtained in a particular iteration.

In some embodiments, the invention encompasses obtaining an estimated value ($v_X^E$) for a particular parameter by calculation. Preferably, the calculation used date and/or information related to the estimated values and, optionally, the acquired signal obtained for one or more other parameters. In an embodiment, a calculated parameter, such as $C_r$, is obtained by calculation from the matched signal evolutions of two (or possibly more parameters), for example as a ratio of signal scaling between acquired and simulated signal evolution.

The estimated value of a parameter obtained by calculation may also be referred to as calculated parameter value ($v_X^C$), which calculated value may be taken as the estimated value of that parameter ($v_X^C = v_X^E$). Although such parameters may be hidden parameters that may be taken into account in the method of the invention, they need not be treated separately as free parameters. In other words, such parameters need not be evaluated by providing a successive values of an assumed value range and need not be obtained by matching. Preferably, such parameters are included in the number N of parameters, although the method is not iterated specifically for such parameters as free parameters.

An example of such a parameter in the context of $^{31}$P MRF conducted *in vivo* is Cr, the concentration ratio of PCr and γATP, which can be calculated from the data related to the matched signal evolutions of the relaxation parameters that are associated with PCr and γATP (e.g., $T_1{}^{\gamma ATP}$, etc).

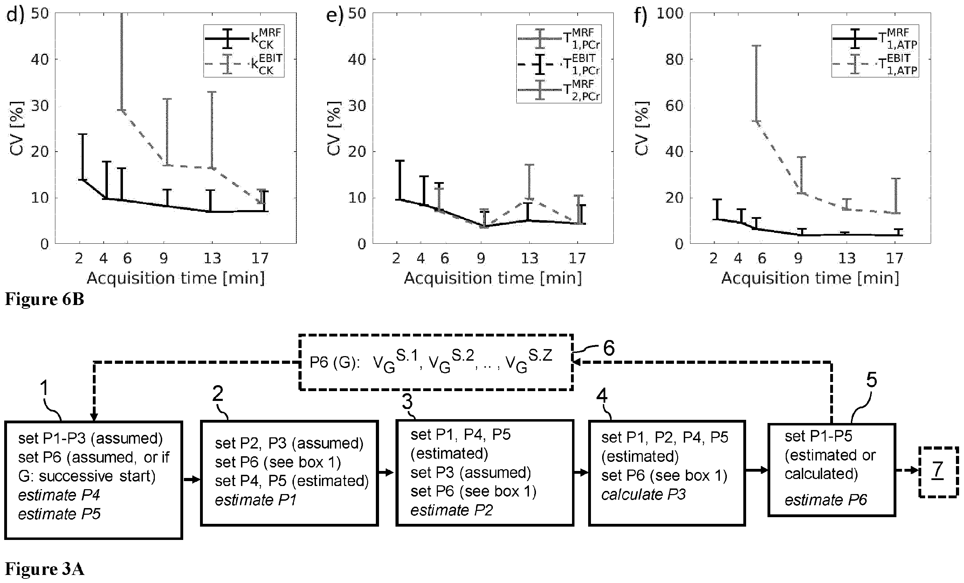

The invention as disclosed above is described with reference to **Figure 3A** in a general manner. In a first embodiment (solid boxes 1-5), the signal evolution of an acquired MRF signal is supposed to be determined by six (6) different parameters (P1-P6) (N=6), the values of which are to be estimated. At the box with numeral 1, the values of parameters P1-P3 and P6 are set to an assumed value taken from the literature (e.g. $v_{P1}{}^{S} = v_{P1}{}^{A}$). Parameters P4 and P5 are considered as free parameters at box 1. Therefore, a plurality of successive values ($v_{P4}{}^{F.1}$, $v_{P4}{}^{F.2}$, ... $v_{P4}{}^{F.Y}$) is established independently for both, P4 and P5. The model is used to generate simulated signal evolutions by using said assumed values for the set parameters and by combining each successive value of P4 with each successive value of P5, resulting in a total of $Z(P4^{F}) \times Z(P5^{F})$ simulated signal evolutions (the number of successive values for P4 times the number of successive values for P5).

Still at box 1 in Fig. 3A, an estimated value is obtained for P4 and P5, namely by matching. In particular, the simulated signal evolutions of P4 and P5 are, independently, compared with the acquired signal, and the best match is determined. The best match is determined by a suitable algorithm, which compares the acquired signal with each of the simulated signal evolutions. The value amongst the successive values of P4 and P5 associated with the best match is used as an estimated value $v_{P4}{}^{E}$, $v_{P5}{}^{E}$.

At box 2, the iterative part is repeated as described above, but now setting the values of parameters P4 and P5 to the estimated value obtained by matching (e.g. $v_{P4}{}^{S} = v_{P4}{}^{E}$), and using P1 as a free parameter by defining a plurality of successive values for P1 ($v_{P1}{}^{F.1}$, $v_{P1}{}^{F.2}$, ... $v_{P1}{}^{F.Y}$). The number of simulated signal evolutions in this case is $Z(P1^{F})$. An estimated value is obtained for P1 by matching with the signal evolutions. At box 3 P1, P4 and P5 are set to the estimated values obtained in boxes 1 and 2, P2 is defined as a free parameter, a plurality of successive values ($v_{P2}{}^{F.1}$, $v_{P2}{}^{F.2}$, ... $v_{P2}{}^{F.Y}$) is established for P2, and an estimated value for P2 is obtained.

At box 4, $v_{P3}{}^{E}$ is obtained by calculation from data related to P1 and P2. In other words, P3 is not considered a free parameter in this example, and no additional signal evolutions are added int his case.

At box 5, a further iteration is added, in that P6 is now considered a free parameter and a plurality if successive values are defined for P6 ($v_{P6}{}^{F.1}$, $v_{P6}{}^{F.2}$, ... $v_{P6}{}^{F.Y}$). An estimate for P6 is then obtained by matching as described above, so that, at the end of box 5, an estimated value has been obtained for all parameters P1-P6. In this manner, the iterations are completed in accordance with this embodiment.

As the above embodiment illustrates, the total number of simulated signal evolutions obtained is $Z(P1^{F}) + Z(P2^{F}) + Z(P4^{F}) \times Z(P5^{F}) + Z(P6^{F})$, instead of $Z(P1^{F}) \times Z(P2^{F}) \times Z(P3^{F}) \times Z(P4^{F}) \times Z(P5^{F}) \times Z(P6^{F})$, according to previously used methods. A significant reduction in the number of signal evolutions is obtained thanks to this iterative method. In accordance with this embodiment (solid boxes in Fig. 3A), there are five groups of parameters (n = 5), a first group with parameters P4 and P5, a second group with parameters P1, a third group with P2, a fourth group with P3, and a fifth group with P6. P3, obtained by calculation, does not add to the number of simulated signal evolutions.

Without wishing to be bound by theory, it is noted that some parameters are sensitive to bias between the true value and the assumed value, while other parameters are not sensitive to such bias. The assumed value ($v_X{}^{A}$) is used for one or more parameters when conducting the method to estimate one or more other, free parameters. The larger the discrepancy between the assumed value ($v_X{}^{A}$) and the true value of the parameter, the larger the error on the estimate that one may expect with respect to the other, free parameters. The present invention encompasses ways of reducing that error.

In an embodiment, the method of the invention comprises, once an estimated value ($v_X{}^{E}$) is obtained for each parameter, repeating the method while using, for one, several or all N parameters (px), the obtained estimated value, or, if available (see further below), a final estimated value ($v_X{}^{E+}$), instead of the assumed value ($v_X{}^{A}$) used initially as a set value for non-free parameters.

Said in a different manner, the invention envisages improving the estimate by using, as a set value ($v_X{}^{S}$), an assumed value ($v_X{}^{A}$) that is closer to the true value than the initially used assumed value, which may have been taken from the literature. In particular, the set value may be an estimated value obtained in a previous iteration or after all iterations of the method. One could refer to the first estimated value as a value ($v_X{}^{E.1}$). The method may then be started again while using $v_X{}^{E.1}$ as $v_X{}^{S}$ instead of $v_X{}^{A}$. Upon completion of the method, a second estimated value, $v_X{}^{E.2}$, is preferably obtained. The method may then be repeated again, using this time $v_X{}^{E.2}$ as said set value $v_X{}^{S}$, and obtaining a third estimated value $v_X{}^{E.3}$. The iterative method may be repeated and the obtained estimates are supposed to get closer and closer to the true value of the parameter, as the bias error is reduced with each repetition of the method.

With reference to the solid boxes in Fig. 3A, this could mean that after conducting the steps in boxes 1-5 as described, the method is started anew, but this time the estimated values obtained in box 5 are directly used as set values in box 1. In other words, for example, $v_{P1}{}^{S} = v_{P1}{}^{E}$, in particular $v_{P1}{}^{E.1}$ instead of $v_{P1}{}^{A}$. At box 2, $v_{P1}{}^{E.2}$ is obtained, which according to the invention is preferably closer to the true value than $v_{P1}{}^{E.1}$.

As a further improvement, the invention envisages obtaining a final estimated value $v_X{}^{E+}$, preferably for one, several or all parameters. The final estimated value may also be used instead of a previously used assumed value for repeating the iterative method.

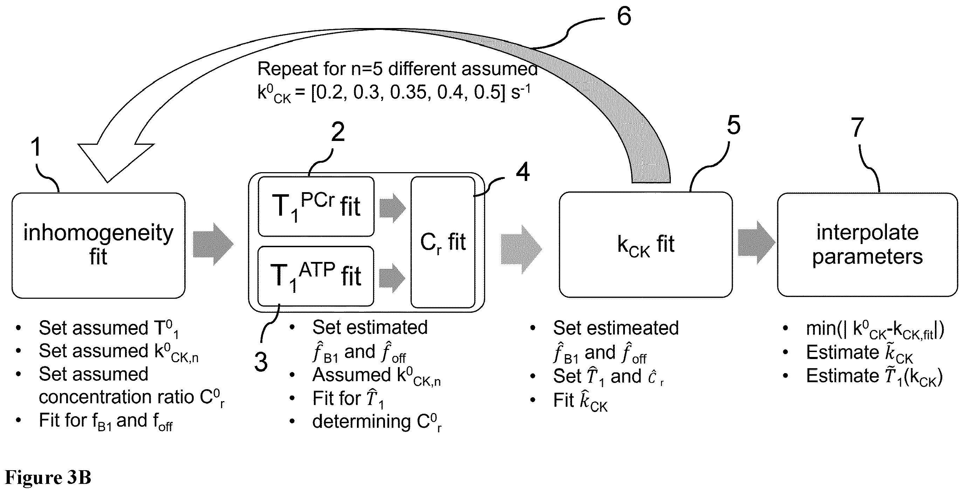

Embodiments for obtaining a final estimated value preferably involve a correlative part and/or functional part, for example as disclosed in more detail further below (numeral 6 in Figs 3A and 3B). Before detailing the functional method, the concepts and application of the global parameter is set forth. It is noted that the global parameter may also be used without the functional part, for example for improving the estimated value obtained by iteration as described above.

In an embodiment, said one or more global parameter is a parameter selected from the group consisting of:

- a parameter having an influence on the estimated value ($v_X^E$) of all other parameters;
- a parameter having the largest impact on the estimated value ($v_X^E$) of one or more other parameters;
- a parameter having an influence on the estimated value ($v_X^E$) of the largest number of the other parameters;
- a parameter on which one or more other parameters, preferably relaxation parameters, can be approximated to depend in a functional, for example linear manner.

Preferably, in the context of a global parameter, said "other parameters" are non-global parameters. If there is one global parameter, said other parameters are the N-1 non-global parameters.

There may be more than just one global parameter, for example two, three or more global parameters, and more generally J global parameters among said N parameters, wherein J is an integer that is 1 or larger and smaller than N. In a preferred embodiment, the method is conducted with one parameter being considered as global parameter, wherein the method can be repeated with another parameter being considered as the global parameter.

The invention also encompasses that a parameter previously defined as a non-global parameter is later defined as a global parameter. A particular parameter may, for example, be temporarily considered as a global parameter, for example for the purpose of conducting a particular run or iteration in accordance with the invention and/or a part of the method of the invention. Furthermore, within the method, a global parameter may also be defined as a free parameter in a similar manner as non-global, free parameters.

For the purpose of the present specification, the symbol X\G, as subscript, for example in $p_{X\backslash G}$ or $v_{X\backslash G}$, may be used to indicate that the corresponding parameter and/or value is part of the parameters px but is not a global parameter and/or is at least temporarily not considered as a particular global parameter, for example a global parameter of a particular run conducted in accordance with an embodiment. Similarly, a non-global parameter may be defined temporarily as a non-global parameter and may later be defined as a global parameter.

In an embodiment, the method of the invention comprises defining a particular parameter (px) as a global parameter ($p_G$) and defining a plurality of $Z(p_G^S)$ successive start values ($v_G^{S.T} = v_G^{S.1}, v_G^{S.2}, ... , v_G^{S.Z}$; T = [1, .... $Z(p_G^S)$)]) of a global value range ($v_G^{S.1} - v_G^{S.Z}$) of said global parameter. As mentioned above, the invention may be worked with one, two or more global parameters.

The symbol $v_G^{S.T}$, where T is an integer given successively to the different values (T = [1, .... $Z(p_G^S)$)]), may be used in this specification to refer to any one of said successive values in particular or to all of them.

In a preferred embodiment, the method further comprises defining one or more non-global parameter (px) as a free parameter ($p_X^F$); and, obtaining an estimated value ($v_X^E$) of said one or more non-global, free parameter for each of said $Z(p_G^S)$ successive start values of said global parameter, preferably in accordance with embodiments disclosed herein above or elsewhere in this specification. The iterative part of the method may be adapted to the global parameter by starting with a successive start value of the global parameter and using that value as a set value $v_G^S = v_G^{S.1}$. The method may be conducted as disclosed above, with some of the remaining parameters being considered as free parameters, and estimated value obtained for the free parameters (and optionally, calculated parameters), and conducting the method including the matching until an estimated value is obtained for each parameter, preferably including the global parameter. In other words, for each $v_G^{S.T}$, an estimated value may be obtained for the remaining parameters px, but preferably also for the global parameter. The estimated value for the global parameter is referred to as $v_G^{E.T}$, and the corresponding estimated value of the non-global parameter as $v_X^{E.T}$ or $v_{X\backslash G}^{E.T}$.

In an embodiment, the invention comprises obtaining an estimated value ($v_G^{E.T}$) of the global parameter ($p_G$) for each successive start value ($v_G^{S.T} = v_G^{S.1}, v_G^{S.2}, ... , v_G^{S.Z}$; Z = [1, .... $Z(p_G^S)$)]) of a global value range ($v_G^{S.1} - v_G^{S.Z}$) of said global parameter ($p_G$). This preferably involves using the global parameter as a free parameter.

In a preferred embodiment, the estimated values ($v_G^{E.T}$) of the global parameter are preferably obtained by:

- setting the values of said non-global parameters ($p_X^F$) to the estimated values ($v_X^{E.T}$) of said parameter ($p_X^F$) obtained with a particular successive start value ($v_G^{S.T}$) of said global parameter; and,
- using said global parameter as a free parameter ($p_G^F$) so as to obtain simulated signal evolutions that allow to obtain an estimate ($v_G^{E.T}$) of said global parameter that is associated with said particular successive start value ($v_G^{S.T}$) of said global parameter.

In a preferred embodiment, using said global parameter as a free parameter ($p_G^F$) comprises defining a plurality of successive values ($v_G^{F.Y} = v_G^{F.1}, v_G^{F.2}, ..., v_G^{F.Z}; Y = 1, ... Zp_G^F$) within an assumed value range ($v_G^{F.1} - v_G^{F.Z}$) of said global, free parameter.

Box 6 in Figure 3A exemplifies a second embodiment of the iterative part, which make use of parameter P6 now being considered as a global parameter. P6 is given a particular role, in that the method of boxes 1-5 is repeated for each of the different successive start values $v_G^{S.T} = v_G^{S.1}, v_G^{S.2}, ..., v_G^{S.Z}$, of the value range $V_G^{S.1} - V_G^{S.Z}$, and that the global parameter is also treated, separately, as a free parameter at box 5 for obtaining an estimated value of the global parameter for each successive start value $v_G^{S.T}$. So with respect to Fig. 3A, at box 1, P6 is set to $v_G^{S.1}$, and parameters P1-P5 are exactly treated as above for obtaining simulated signal evolutions, conducting matching and obtaining estimates of P1-P5 at box 4. With $v_G^{S.1}$, the estimates of the non-global parameters may be referred to as $v_{X\backslash G}^{E.1}$.

At box 5, P6 is treated as a free parameter and box 5 thus comprises defining a plurality of successive values ($v_G^{F.Y} = v_G^{F.1}, v_G^{F.2}, ..., v_G^{F.Z}; Y = [1, ... Zp_G^F]$) within an assumed value range ($v_G^{F.1} - v_G^{F.Z}$) of said global, free parameter P6, as described above.

For the remaining parameters P1-P5, the estimates obtained at boxes 1-4 are used as set values ($v_{X\backslash G}^{E.1}$). At box 5, P6 is the only free parameter (as above). Still at box 5, matching with simulated signal evolutions is conducted and an estimate of the global parameter P6 is obtained, which estimated value is referred to as $v_G^{E.1}$, since it is obtained when using $v_G^{S.1}$ as a set value for P6 in boxes 1-4. After box 5, the method is started again in box 1, but this time using the successive start value $v_G^{S.2}$ as the set value for P6. At the end of the second repetition of boxes 1-5, a second estimate for the non-global parameters $v_{X\backslash G}^{E.2}$ and an estimate $v_G^{E.2}$ of the global parameter is obtained. The method is repeated until an estimate $v_G^{E.T}$ of the non-global and global parameters is obtained for each of the successive start values $v_G^{S.T}$. In other words, the number of estimates of the global and non-global parameters is $Z(p_G^S)$.

$Zp_G^F$ is preferably larger than $Zp_G^S$ and/or the average numeric distance between successive values is preferably shorter in the assumed value range ($v_G^{F.1} - v_G^{F.Z}$), where the global parameter is a free parameter, than in said global value range ($v_G^{S.1} - v_G^{S.Z}$) of the global parameter. This means that when using said global parameter as a free parameter, more successive values are provided than in the range of successive start values. The successive start values of the global parameter are preferably sparser, whereas the successive values of the global parameter when being a free parameter are finer and characterized by shorter gaps between successive values. In an embodiment, $Zp_G^S$ is an integer of 2 or larger, preferably 3 or larger, and optimally about 5. Preferably, $Zp_G^S$ is 15 or smaller, more preferably 10 or smaller.

Preferably, an estimated value for the global parameter is obtained for each iteration that has started with setting the value of the global parameter to one of said successive start values.

One may also consider that the iterative part can be nested and/or comprises nested iterative parts, with the global parameter being a nesting parameter, which may appear at an outer and at the inner level of the nested iteration.

**Figure 3B** can be regarded as a more specific, practical implementation of the method described with respect to Fig. 3A. In Fig. 3B, $T_1$ (of γATP and PCr) correspond to P1 and P2, concentration ratio $C_r$ corresponds to P3 and P4 and P5 correspond to $f_{B1}$ and $f_{OFF}$, respectively. The term "fit" on box 1 corresponds to obtaining an estimate by matching, whereas "set" means using a set value $v_X^S$, for example an assumed value $v_X^A$ for $T_{1\gamma ATP}$ and $T_{1PCr}$, respectively. The wording "Set assumed $k^0_{CK,n}$" in box 1 means that $k_{CK}$ is a global parameter, for which the corresponding successive start value, as shown at 6 in Fig. 3B, is used. In boxes 2 and 3, the estimates for $T_1$ values are obtained by matching. At box 4 $C_r$ is obtained by calculation from the two fitted signal evolutions as a ratio of signal scaling between measured and simulated signal evolution, and is thus a calculated value. In box 5, $k_{CK}$, here considered as a global parameter, is treated as a free parameter and an estimate thereof is obtained by fitting/matching as described in the corresponding box 3 of Fig. 3A.

In Fig. 3B, as well as in some other figures, the suffixes 0, ^ and ~ are used as follows: "0" is used for indicating that this is a set, assumed value ($v_X^S = v_X^A$) or for a set start value ($v_G^{S.T}$) in case of a global parameter, "^" is used for indicating a set, estimated value (such as $v_G^{E.T}$ and $v_X^{E.T}$), and "~" for indicating a final estimated value (such as $v_G^{E+}$ and $v_{X\backslash G}^{E+}$).

As previously discussed, parameters may be grouped, and this applies also for the global parameter. A group is preferably composed of one or more parameters that are treated simultaneously as free parameters, or, if applicable, as a calculated parameter. Within a group, the number of modelled signal evolutions increase in an exponential manner, depending on the number of free parameters and the number of successive values of the free parameters in a group. These signal evolutions are added to the number of signal evolutions of another group, so that the total number of signal evolutions will be reduced. In Fig. 3A, including boxes 5 and 6, one may say there are six groups, a group containing P4 and P5, a group for each of P1, P2, and two groups for P6, once when defined as a free parameter (box 5) and once when defined as a global parameter (box 6). P3 also is part of a group, although P3 is not a free parameter and the group of P3 does not add to the number of simulated signal evolutions.

In an embodiment, the method comprises:

- splitting said N parameters $p_1$-$p_N$ in n groups, such that each group contains one or more different parameters;
- selecting a first group comprising one or more (J) global parameter ($p_G$), wherein the parameters in each of the preferably n-1 remaining groups comprise one or more parameters, wherein n-1 ≥ 1;
- defining $Z(p_G^S)$ successive start values of a global value range for said global parameter ($p_G$) (see above);
- selecting one group of said n-1 remaining groups, wherein the one or more parameters in that one group are free parameters ($p_X^F$) and the estimated values ($v_X^E$) of said free parameters of that one group are to be determined by matching with simulated signal evolutions;
- if n-1 > 2, attributing a set parameter value ($v_X^S$) to each of the parameters in the remaining n-2 groups, wherein said set parameter value is preferably selected as defined in (i) and (ii) as disclosed elsewhere in this specification.

In a preferred embodiment, obtaining a dictionary of simulated signal evolutions comprises:

I. using, for $p_G$, a value selected from said $Z(p_G^S)$ successive start values;
II. if n-1 >2, using, for the parameters of said n-2 groups, said set parameter value ($v_X^S$);
III. defining for each of said free parameters ($p_X^F$) of said one selected group, a plurality of successive parameter values ($v_X^{F.Y} = v_X^{F.1}, v_X^{F.2}, ... , v_X^{F.Z}$) of an assumed value range ($v_X^{F.1}$ - $v_X^{F.Z}$);
IV. creating said dictionary wherein at least one simulated signal evolution is obtained for each of said plurality of successive parameter values ($v_X^{F.Y}$) of said free parameters.

Preferably, said method comprises;

- obtaining an estimated value ($v_X^{E.T}$) for said free parameters by matching a simulated signal evolution with said acquired signal, or by calculation as disclosed elsewhere;
- if applicable, selecting another group among said n-2 groups and repeating the step of obtaining an estimated value ($v_X^{E.T}$), with said other group being the one selected group containing the free parameters or a calculated parameter, wherein repetition is conducted until an estimate value is obtained for each non-global parameter, and preferably also for the global parameter.

Preferably, said method further comprises repeating the steps of obtaining said dictionary of simulated signal evolutions and obtaining an estimated value ($v_X^{E.T}$) while selecting for $p_G$ another value from said $Z(p_G^S)$ successive start values until said method has been repeated for all said $Z(p_G^S)$ successive start values.

The different estimated values obtained for the (one or more) global parameter may be symbolized by $v_G^{E.T}$ (= $v_G^{E.1}, v_G^{E.2} , ... v_G^{E.Z}$), wherein each $p_G^{E.T}$ is associated with the corresponding successive start value $p_G^{S.T}$ that was used to obtain the estimated value.

Similarly, for each of the remaining, non-global parameters, an estimated value is preferably obtained with respect to each of the successive start values of the global parameter, wherein said estimated values may be symbolized as $v_{X\backslash G}^{E.T}$, meaning "the estimated value $v_X^E$ of px obtained with the value of the global parameter being set as $v_G^{S.T}$".

In accordance with the above, the iterative part including one or more global parameter preferably yields pairs of successive values obtained with the global parameter and the corresponding estimates. With respect to the global parameter, the pairs may be referred to as $v_G^{E.1}, v_G^{S.1}$ (the first pair); $v_G^{E.2}, v_G^{S.2}$ (the second pair); ... ; $v_G^{E.Z}, v_G^{S.Z}$ (the last pair). For example, $v_G^{E.1}, v_G^{S.1}$ corresponds to "the estimate of the global parameter $v_G^{E.1}$ obtained with the global parameter used as a free parameter, the method being conducted with the first of said successive start values of the global parameter".

With respect to the non-global parameters, the pairs may be referred to as $v_G^{S.1}, v_X^{E.1}$ (the first pair); $v_G^{S.2}, v_X^{E.2}$ (the second pair); ... ; $v_G^{S.Z} , v_X^{E.Z}$ (the last pair). For example, the pair $v_G^{S.1}, v_X^{E.1}$ corresponds to "the estimate of the non-global parameter $v_X^E$ obtained with the global parameter being set to the first of said successive start values of the global parameter when considered a free parameter".

Typically, with the set value of the global parameter, the estimate $v_X^{E.T}$ is obtained for the non-global parameter, and at the end of the iterative step the estimate $v_G^{E.T}$ for the global parameter is obtained.

As mentioned above, the present invention provides, in some embodiments, obtaining a final estimated value preferably involve a correlative part and/or functional part. The final estimated value is preferably considered to be closer to the true value than previously established estimated values.

The present inventors surprisingly found that it is possible to correlate successive start values of the global parameter with corresponding estimates of the global parameters, and/or to correlate the successive start values of the global parameter with corresponding estimates of non-global parameters.

In an embodiment of the invention, a dependency of one or more non-global or other parameters from said global parameter, and/or an influence of said global parameter on one or more non-global parameters, for example a correlative relationship, can be established between estimated values ($v_X^{E.T}$) of a plurality of estimated values of one of said one or more non-global parameters when depending on the successive start values ($v_X^{S.T}$) of said global parameter.

In an embodiment, the above-mentioned relationships, such as functional and/or correlative relationships and/or dependencies of one or more non-global parameters from said global parameter can be found by mathematical methods such as interpolation or artificial neural network (ANN) approaches.

The above-mentioned relationships, such as functional and/or correlative relationships and/or dependencies, may be used to determine final estimates of the parameters in accordance with preferred embodiments of the present invention. This part of the method of the invention may be preferably conducted after the iterative part disclosed herein above (box 5 in in Fig. 3A).

In an embodiment, the invention provides a method for determining a final estimated value ($v_G^{E+}$) of said global parameter ($p_G$).

In an embodiment, obtaining $v_G^{E+}$ comprises defining a cost function d = $f(v_G^{S.T}, v_G^{E.T})$, in which an estimated value ($v_G^{E.T}$) of the global parameter ($p_G$) is mathematically related with the successive start value ($v_G^{S.T}$) of the global parameter that was used for obtaining said estimated value ($v_G^{E.T}$) of the global parameter ($p_G$). Preferably, the final estimated value ($v_G^{E+}$) of said global parameter ($p_G$) is obtained by minimizing the cost function. In other words, the $v_G^{E+}$ is the value of $p_G$ where the cost function has a minimum.

In an embodiment, the cost function d is obtained by an artificial neural network (ANN) approach that establishes a correlation between different points $P_T(v_G^{E.T}, v_G^{S.T})$.

In an embodiment, obtaining a final estimated value ($v_G^{E+}$) of said global parameter comprises determining the difference between a particular successive start value ($v_G^{S.T}$) and the estimated value ($v_G^{E.T}$) obtained with the corresponding successive start value ($v_G^{S.T}$) of said global parameter, said difference being $d_Y = v_G^{S.T} - v_G^{E.T}$.

In an embodiment, the cost function d is obtained by interpolation, preferably by interpolating the points $P_T(v_G^{S.T}; v_G^{E.T} - v_G^{S.T})$.

In a preferred embodiment using a functional approach of an interpolation, the cost function is: d = | $v_G^{E.T}$ - $v_G^{S.T}$|. Preferably, the final estimated value ($v_G^{E+}$) of said global parameter ($p_G$) is given by the equation $v_G^{E+}$ = min (| $v_G^{S.T} - v_G^{E.T}$ |).

In an embodiment, the invention comprises obtaining a final estimated value ($v_{X\backslash G}^{E+}$) for one or more of said parameters (px), preferably for one or more of said parameters ($p_{X\backslash G}$) other than said global parameter ($p_G$). Preferably, this is done once the final estimated value ($v_G^{E+}$) for the (one or more) global parameter has been obtained.

Preferably, obtaining $v_{X\backslash G}^{E+}$ comprises defining a function e = $f(v_{X\backslash G}^E, v_G^{S.T})$ in which the estimated value ($v_{X\backslash G}^E$) of said other, non-global parameter ($p_{X\backslash G}^E$) depends on the corresponding successive start value ($v_G^{S.T}$) of a global parameter ($p_G$) from which said estimated parameter ($v_{X\backslash G}^E$) value was obtained. As has been disclosed elsewhere, the invention may comprise obtaining an estimated value ($v_X^{E.T}$, or $v_{X\backslash G}^{E.T}$) of said one or more non-global free parameter ($p_X^F$) for each successive start value ($v_G^{S.T}$) of an assumed start value range ($v_G^{S.1} - v_G^{S.Z}$) of said global parameter ($p_G$). The estimated value $v_X^{E.T}$ preferably corresponds to (and/or is obtained with) the successive start value of the global parameter.

The function e may be obtained by mathematical methods such as interpolation or artificial neural network (ANN) approaches, for example. Preferably, e is obtained by interpolating the points $P(v_G^{S.T}, v_{X\backslash G}^{E.T})$.

In an embodiment, one or more non-global parameters are considered as mathematically related with, for example correlated with and/or dependent on said global parameter by way of a linear functional relationship and/or wherein an interpolation or artificial neuronal network approach is conducted in view of obtaining a functional relationship.

The invention is preferably not limited with respect to the nature of the function e. Any function may be defined that can be used to express, at least approximately, the relationship between $p_{X\backslash G}^{E.T}$ and $v_G^{S.T}$, for example the dependency of $v_{X\backslash G}^{E.T}$ from $v_G^{S.T}$. It is noted that the relationship is preferably assumed only within a defined, preferably relatively narrow range. The range may encompass the entire assumed start value range $v_G^{S.1} - v_G^{S.Z}$ of said global parameter, or just a part of that range, preferably the part comprising the final estimated value of the global parameter.

In an embodiment, a linear or quadratic relationship between $v_{X\backslash G}^{E.T}$ and is assumed, such that e is defined as a linear and/or quadratic function, obtained, for example, by interpolation of the points $P(v_X^{E.T}; v_G^{S.T})$.

With a final estimated value of the global parameter being available, the method preferably comprises defining the final estimated value ($v_{X\backslash G}^{E+}$) of said one or more other, non-global parameter ($p_{X\backslash G}$) as the value of said parameter in said function e where the global parameter ($p_G$) has the final estimated value ($v_G^{E+}$).

In conclusion, the final estimated value of the non-global parameters can be obtained by defining said function e and identifying the value of that non-global parameter in function e corresponding to the final estimate of the global parameter.

It is noted that the methods and steps of the present invention are preferably computer implemented methods and/or steps of the invention and are preferably conducted by a computer and/or in an electronic data processing entity. Preferably, the methods and/or steps of the invention are integrated in a software.

In an embodiment, the computer and/or data processing entity is preferably integrated, part of and/or connected to an NMR apparatus. The connection may be selected from wireless and cabled connections.

In some embodiments, the invention comprises computer programs and/or software suitable to conduct the method and/or steps of the invention. The computer program and/or software may be comprised on a suitable, computer readable data carrier, such as a computer readable memory, including ROM and ROM memories, including hard disks, CDs, CD-RWs, DVDs, DVE-RWs, flash memory, USB sticks, computer servers, static RAM, dynamic RAM, for example.

The method of the invention may be used for the purpose of diagnosis. For example, values, in particular the final estimated values of parameters, may be compared with reference values, and depending of the comparison, the presence of a condition, such as a disease, for example cancer or psychological disease as schizophrenia, may be determined. Parameters that may have diagnostic value may include, for example, relaxation parameters, concentration ratios, chemical exchange rates.

In an embodiment, the diagnostic method may be conducted on the basis of an MR Fingerprinting measurement conducted previously, for example on the basis of a signal evolution, which has been acquired *in vivo* before the method of the invention is conducted.

In other embodiments, the method of the invention encompasses non-diagnostic methods. In particular, the present invention is directed to signal processing, signal treatment and/or signal analysis. The invention may be used, for example, to improve a method of diagnosis, without directly being diagnostic, or may be used to accelerate the time until a diagnosis can be made.

While certain of the preferred embodiments of the present invention have been described and specifically exemplified above, it is not intended that the invention be limited to such embodiments. Various modifications may be made thereto without departing from the scope and spirit of the present invention, as set forth in the following claims. Herein below, examples of the invention are disclosed. These examples are for illustration only and are not intended to limit the scope of the present invention.

## Examples

### I. Introduction

The purpose of this study is to demonstrate the feasibility of the IP-$^{31}$P-MRF at 7T in human brain, to evaluate its robustness and to compare the test-retest reproducibility to EBIT method. Firstly, IP-$^{31}$P-MRF is validated using simulation providing error estimation. To address the problematic of creating and fitting large multi parametric dictionaries, we introduce the IP-$^{31}$P-MRF solving approach, which combines a iterative parameter estimation with small dictionaries and an interpolation approach to converge to a bias free estimation. Secondly, in vivo measurements on human brain using both measurement methods are conducted. Lastly, reproducibility comparison is performed between the two methods.

In formulas, tables and figures discussed in the following examples, the suffixes "0", "^" and "~" are occasionally used as described above with respect to Fig. 3B, for indicating assumed, estimated and final estimated values of the corresponding parameter, respectively, corresponding to the suffixes A, E and E+ used in the description herein above. In case of the global parameter ($k_{CK}$ in this example) $k^0_{CK},n$ is used for referring to the successive start values as used in the general description above, where n corresponds to the suffix T.

### II. Methods

*1. Pulse sequence.* The IP-31P-MRF approach is a b-SSFP like excitation scheme with variable flip angle FA of phase alternating RF pulses. 1D Localisation is achieved by a slice selective 1.5 ms Shinar-le-Roux (SLR) pulse. TR is set constant to 18.9 ms with a sampling rate of 256 points per 16.67 ms acquisition time, resulting in a 60 Hz spectral resolution and 15360 Hz bandwidth (BW). The scheme consists of 3 parts (**Figures 1A** and **1B**)[1]. Part A starts with an inversion pulse followed by 699 RF excitations with the amplitude of which follows a sinusoidal function to be sensitive for $T_1$ and $T_2$ changes. Part B (still Fig. 1A) contains abrupt RF excitation changes to capture yB+ inhomogeneities and off resonances [1]. The scan time per cycle of the first two parts, including 5 second relaxation time in between repetitions, is 18.5s. Part C (Fig. 1B) is used to increase $k_{CK}$ sensitivity with 244 FAs in sinusoidal pattern with 4 sec relaxation time in between each cycle (Fig. 1B), resulting in a scan time of 9s. Following the first asymmetric inversion pulses [2], Pi and PCr are inverted. After 185 FAs and a short 400 ms relaxation time, a second asymmetric inversion pulse with opposite pulse profile to invert $\alpha, \beta, \gamma$-ATP is used (Figure 1B). Each measurement has one dummy scan prior to reach steady state. Last, a $B_0$ map is acquired to incorporate the off-resonance distribution into the dictionary.

*2. Fingerprint simulation.* A dictionary is created for each subject using the Bloch-McConnel equations in a two-pool exchange model with the 2 pools a and b, representing PCr and γATP, respectively [4]. Since the b-SSFP band pass filter is narrower with approximately 60 Hz then for the CK-MRF, the 16.1 Hz frequency split due to J-coupling has a larger effect on the signal. Therefore, we split the γATP pool in two sub-pools, b1 and b2, with different resonance frequency f0, γATP ± 8.05 Hz. No exchange of magnetization between the two sub-pools is assumed and the equilibrium magnetisation is split evenly. To decrease simulation complexity the discrete magnetisation equation in between two pulses is described as ML the longitudinal magnetisation and MT the transverse magnetisation with

$$(4.1) \qquad M_L(n+1) = e^{A_L \Delta t}\, M_L(n) + R$$

and

$$(4.2) \qquad M_T(n+1) = e^{A_T\,\Delta t} M_T(n)$$

where I is the identity matrix, Δt the dephasing time, the magnetisations are

$$(4.3) \qquad \mathbf{M}_L = \begin{bmatrix} M_z^{\mathrm{a}} & M_z^{\mathrm{b_1}} & M_z^{\mathrm{b_2}} \end{bmatrix}^T$$

$$(4.4) \qquad \mathbf{M}_T = \begin{bmatrix} M_x^{\mathrm{a}} & M_y^{\mathrm{b}} & M_x^{\mathrm{b_1}} & M_y^{\mathrm{b_1}} & M_x^{\mathrm{b_2}} & M_y^{\mathrm{b_2}} \end{bmatrix}^T$$

and longitudinal recovery rate is

$$(4.5) \qquad \mathbf{R} = 1 - \begin{bmatrix} e^{T_1^a \Delta t} & 0.5 C_r (e^{T_1^b \Delta t}) & 0.5 C_r (e^{T_1^b \Delta t}) \end{bmatrix}^T$$

with the concentration ratio:

$$(4.6) \qquad C_r = \frac{M_0^{\mathrm{a}}}{M_0^{\mathrm{b}}}.$$

Further the free precession, relaxation and magnetization exchange matrices can be described as

$$(4.7) \qquad \mathbf{A}_L = \begin{bmatrix} \dfrac{1}{T_1^{\mathrm{a}}} - k_f & k_r & k_r \\[2ex] 0.5 k_f & \dfrac{1}{T_1^{\mathrm{b}}} - k_r & 0 \\[2ex] 0.5 k_f & 0 & \dfrac{1}{T_1^{\mathrm{b}}} - k_r \end{bmatrix}$$

and

$$(4.8) \quad \mathbf{A}_T = \begin{bmatrix} \frac{1}{T_2^{\mathrm{a}}} - k_f & \omega_{\mathrm{a}} & k_r & 0 & k_r & 0 \\ \omega_{\mathrm{a}} & \frac{1}{T_2^{\mathrm{a}}} - k_f & 0 & k_r & 0 & k_r \\ 0.5 k_f & 0 & \frac{1}{T_2^{\mathrm{b}}} - k_r & \omega_{\mathrm{b}_1} & 0 & 0 \\ 0 & 0.5 k_f & \omega_{\mathrm{b}_1} & \frac{1}{T_2^{\mathrm{b}}} - k_r & 0 & 0 \\ 0.5 k_f & 0 & 0 & 0 & \frac{1}{T_2^{\mathrm{b}}} - k_r & \omega_{\mathrm{b}_2} \\ 0 & 0.5 k_f & 0 & 0 & \omega_{\mathrm{b}_2} & \frac{1}{T_2^{\mathrm{b}}} - k_r \end{bmatrix}$$

with the forward creatine kinase rate kf, the reverse rate

$$(4.9) \quad \mathrm{k_r = kf \cdot Cr,}$$

$T_1^X$ the longitudinal and $T_2^X$ transverse relaxation times of PCr and $\gamma$ATP and the precession speed

$$(4.10) \quad \omega_X = 2\pi(f_{X,0} + f_{off}).$$

$M^0{}_{\mathrm{PCr}}$ correction [3], $B_0$ distribution and a linear coil sensitivity approximation of the surface coil are incorporated in the simulation using a weighted sum of isochromats. $\gamma B^{1+}$ and the FA are assumed to be the same for all pools. The effective excitation FA, $\varphi_{eff}$, in each sub-slice $n_f = [1, .., N_f]$ was found by

$$(4.11) \quad \phi_{eff,n_f} = C_{SP,n_f} \cdot C_{CS,n_f} \cdot f_{B_1} \cdot \phi,$$

where $\varphi$ is the FA of the MRF pattern, $C_{SP}$ is the excitation pulse profile, $C_{CS}$ is the coil sensitivity profile and the $B_1$ scaling factor $f_{B1}$ is

$$(4.12) \quad f_{B_1} = \frac{B_1}{B_{1,\mathrm{nom}}},$$

with $B_{1,\mathrm{nom}}$ the nominal transmit field strength to reach $\varphi$ and $B_1$ is the actual transmit magnetic field strength seen. *3. Dictionary generation and parameter matching.* For all dictionaries $T_2{}^{ATP}$, $T_2{}^{PCr}$ the resonance frequencies $f_0{}^{PCr}$ and $f_0{}^{ATP}$ are set to 30 ms, 135 ms, 0 Hz and 301 Hz, respectively, resulting in 6 remaining parameters to fit, with with $f_{B1}$, the mean off-resonance $f_{off}$, $T_1{}^{PCr}$, $T_1{}^{ATP}$, Cr and $k_{CK}$. Fitting is proceeded with the inner product of the signal evolution normalized by the L2 norm of the measured pattern and the dictionary entries.

To estimate these parameters, we introduce our IP-³¹P-MRF approach, combining an iterative and preferably an interpolating approach to reduce dictionary creation and fitting time drastically (Fig. 3B). This non-convex problem is solved using n triplets of dictionaries for each subject, where n is the number of $k^0{}_{CK}$ starting values.
*3.1 Iterative part.* The first iteration is to determine the $f_{B1}$, and $f_{off}$. For each $k^0{}_{CK}$, n, a dictionary with $f_{B1}$, ranging in 76 values from 0.60 to 1.35 and $f_{off}$ ranging in 21 values from -10 Hz to 10 Hz is simulated. $T^{PCr}$, $T^{ATP}$ and *Cr* are fixed to start assumptions with 5s, 1s and 0.75 respectively. In the first iteration, n estimations of $f_{B1}$ and $f_{off}$ ($f_{B1}{}^E$, $f_{off}{}^E$) are found by fitting the concatenated PCr pattern of part A and B, with the signal evolution ATP part A.
In the second iteration, relaxation times and concentration ratio of PCr and $\gamma$ATP will be determined. The estimated parameters are fed forward to create the second set of dictionaries. $T_1{}^{PCr}$ and $T_1{}^{ATP}$ values are varied with 31 steps and a 2.5% increase/step from a start value depending on the $k^0{}_{CK}$. $T_2{}^{PCr}$ values are varied with 11 steps and a 10% increase/step from a start value depending on the $k^0_{CK}$ (Table 1). PCr pattern are fitted using part A by assuming the start assumption of $T1^{\gamma ATP}$ and $T1^{Cr}$; $\gamma ATP$ are also fitted similarly by assuming the start assumption $T1^{PCr}$. Concentration ratio Cr is estimated (calculated) by the scaling factor of non-normalized measured signal to the matching dictionary entry.

In the last iteration, $k_{CK}$ value will be determined. The last set of dictionaries are simulated for part C with the prior estimated 5 parameters to estimate $k_{CK}^E$. The dictionary with $k_{CK}$ values are varied with 31 steps and a 4% increase/step from a start value depending on $k^0_{CK}$. The fitting is proceeded with the concatenated part C part of the (acquired) PCr and $\gamma ATP$ signal.

*3.2 Interpolation part.* Each $k_{CK}^{E,n}$ is biased estimate dependent on the difference between the true $k_{CK}$ and $k^0_{CK,n}$. We can assume a linear behavior of this dependency, as demonstrated with simulations. The final estimates $k_{CK}^{E+}$ is found by minimizing the cost function expressed as the absolute difference

$$(4.13) \qquad\qquad \tilde{k}_{CK} = \min(|k^0_{CK} - \hat{k}_{CK}|).$$

Furthermore, simulations showed that the relaxation parameters can be approximated being linearly dependent on $k_{CK}$, with a bias free estimation of relaxation parameters for $k^0_{CK}$ equals $k_{CK}^{E+}$. To correct the bias, interpolations of the least-square fit (LQF) of $T_1(PCr)^E$, $T_1(ATP)^E$, and $T_2(PCr)^E$ over $k^0_{CK}$ are used. The final estimates of $T_1(PCr)^{E+}$, $T_1(ATP)^{E+}$ $T_2(PCr)^{E+}$, and $T_2(PCr)^{E+}$ are obtained from the linear LQF-function at $k_{CK}^{E+}$.

*4. Error estimation by simulations.* To estimate the matching error (ME) introduced by the matching approach, simulations are performed for IP-$^{31}$P-MRF. The full estimation procedure is examined by deviate one ground truth value, leaving all other parameters in their initial ground truth value ($k_{CK}$ = 0.35 s$^{-1}$, $T_1^{PCr}$ = 5.0s, $T_2^{PCr}$ = 135 ms, $T_1^{ATP}$ = 1.0 s, $T_2^{ATP}$ = 30 ms, Cr = 0.75, $f_{B1}$ = 1, $f_{off}$ = 0 Hz. The deviation of each ground truth value is ranged by 50% from its initial ground truth values with a 5% step. The dictionaries have a quantification step of 2.5% of the ground truth value.

The noise robustness and the relationship between parameters is examined using Monte Carlo simulations. A set of 100 patterns is created for each signal to noise ratio (SNR$_P$ =[5.8 8.6 11.5 12.1]; SNR$_A$=[3.8 6.3 9.6 15 22 100]) based on the ground truth values ($f_{B1}$ = 1 , $f_{off}$ = 0 Hz). Each pattern with noise is evaluated in the iteration process for different $k^0_{CK}$, n = [0.15, 0.20, 0.25, 0.30, 0.35, 0.40, 0.45, 0.55] s$^{-1}$ values. For each $k^0_{CK}$, n mean and standard deviation (STD) of the estimated parameters are calculated. The results are used to evaluate the mean and STD of the interpolation part with n = [3, 5, 8] starting values using $k^0_{CK}$, n = [0.2, 0.35, 0.5] s$^{-1}$ and the whole set of $k^0_{CK}$, n, respectively.

The relationship between the starting value $k^0_{CK}$, the cost function (4.13) and the final estimated parameters $T_1(PCr)^{E+}$, $T_1(ATP)^{E+}$, and $T_2(PCr)^{E+}$ is evaluated using the set of simulated parameters of SNR = 100 dB.

*5.* In vivo *study protocol.* The in vivo experiments were performed to show the feasibility of IP-$^{31}$P-MRF and to compare accuracy and reproducibility with EBIT. The data were acquired from 6 healthy subjects (3 females and 3 males; age 18-30 years), who provided written informed consent. All MR experiments were performed on a 7T/68cm MR scanner (Siemens Medical Solutions, Erlangen, Germany) with $^1$H quadrature surface coil (10cm-diameter) and a single-loop $^{31}$P coil (7cm-diameter) for the occipital lobe.

$B_0$ shimming was performed using 3D map shim and PCr line width measurement was preceded each time to control the spectral quality for fair comparison between the two methods. The EBIT sequence consisted of an asymmetric adia-batic inversion pulse applied at -1.25 ppm (Module I: inversion of ATPs) and at 1.25 ppm (Module II: inversion of PCr and ATPs) respectively followed by multiple inversion delay (td) and a Shinnar-Le-Roux (SLR) excitation pulse (TR = 4 s; td = 60, 200, 400, 670, 1590, 3000 ms; averages= 16; bandwidth= 6000 Hz; 1 dummy scan, slice thickness= 20mm). Reference scans were acquired using the same se- quence without the inversion pulse (TR = 4 s and 20 s; averages= 16 and 6; 1 dummy scan). Module I and II are targeting for PCr → $\gamma ATP$ and Pi → $\gamma ATP$, respectively. the total scan duration of EBIT and reference scans was 17 min 4 s. The IP-$^{31}$P-MRF sequence was used to estimate the relaxation parameter and MT effect in PCr → $\gamma ATP$ in the same 20 mm slice as EBIT. The sequence was performed as described above with the transmit/receive frequency centered at the resonance frequency of PCr. 37 measurements of part A and B and one dummy scan were applied, followed by the same number of measurements and dummy scans of part C. A $B_0$ map (6s) was acquired afterwards to measure off-resonance distribution in the slice. The total scan time was 17 min 24 s. For the interpolation part n = 5 start values $k^0_{CK}$, n = [0.2, 0.3, 0.35, 0.4, 0.5] s$^{-1}$ were used. To evaluate test-retest reproducibility, each volunteer was scanned twice with a 10 min of break between sessions. The order of EBIT and MRF applications was randomized to avoid systematic error.

*6. $^{31}$P MRS data anlysis.* All data processing were performed using MATLAB (the MathWorks, Natick, MA, USA). 6 Hz of line broadening was applied to fid before Fourier transformation. Voigt lineshape was used for fitting of each $^{31}$P peaks. The fully relaxed $^{31}$P spectra (TR = 20 s) was used to calculate the equilibrium PCr/yATP magnetization ratio. Normalized longitudinal magnetization was acquired using the reference scan (TR = 4 s). The intensity of peaks acquired from Module I and II are concatenated. Fitting of 2 pool exchange model was performed using the least-square function *lsqcurvefit.*

*7. Statistical analysis.* Statistical analysis is performed using matlab (MathWorks, see above). Coefficient of variation

$$(4.14) \qquad CV = \frac{\sqrt{E[(X - E[X])^2]}}{E[X])},$$

Where E[X] is the expected value, is calculated to assess test-retest reproducibility between two sessions for both methods. The alteration of CV over the scan duration is evaluated to compare the efficiency of the methods. The Bland-Altman comparison is used to compare EBIT to IP-$^{31}$P-MRF for the repeated measurement. SNR of the measured IP-$^{31}$P-MRF pattern is estimated using the matlab *snr* function.

III. Results

*III.1 Set values and global parameter values.* **Table 1** below shows the assumed parameter values $T_{1(PCr)}^{A}$, $T_{1ATP}^{A}$ for different starting values of the global parameter, $k_{CK}^{F}$ used *in vivo.* $T_{1(PCr)}^{lb}$, $T_{1ATP}^{lb}$ and $k_{CK}^{lb}$ are the lower bounds (lb) of the dictionaries for each starting value.

**Table 1:**

| $k_{CK}^{0} \; [s^{-1}]$ | 0.20 | 0.30 | 0.35 | 0.40 | 0.50 |
|---|---|---|---|---|---|
| $T_{1,lb}^{PCr} \; [s]$ | 3.00 | 3.25 | 3.50 | 3.75 | 4.00 |
| $T_{1,lb}^{ATP} \; [s]$ | 0.65 | 0.62 | 0.60 | 0.58 | 0.55 |
| $k_{CK,lb} \; [S^{-1}]$ | 0.10 | 0.10 | 0.11 | 0.12 | 0.13 |

*III.2 MRF simulation results*

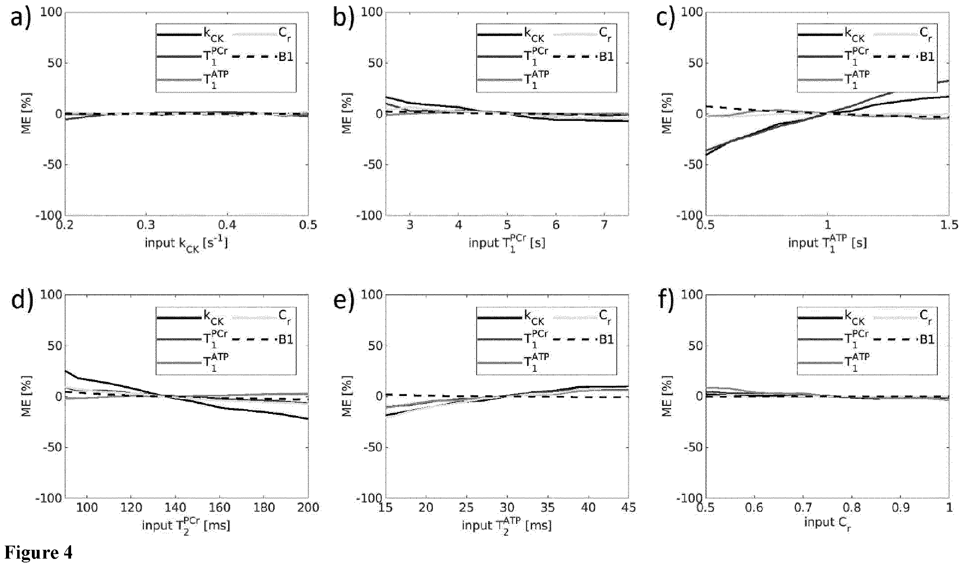

**Figure 4** shows the matching error (ME) of each parameter, due to input errors (IE) by bias in the fixed parameters or MEs in a previous iteration step. In the first iteration step ME on $f_{B1}$ estimation is mainly introduced by IE of and $T_2^{PCr}$ and $k_{CK}$. The concentration ratio, $T_1^{ATP}$ and $T_2^{ATP}$ have no effect on the estimation. Off resonance $f_{off}$ shows negligible MEs depending on bias in fixed parameters, insuring accurate $f_{off}$ estimation (not shown).

In the second iteration the ME of the relaxation parameters of PCr are affected by $k_{CK}$ and Cr. $T_1^{PCr}$ is robust against ME of the previous step. Also, $T_1^{ATP}$ and Cr are only mildly affected by IE, with the ME not exceeding 25%. Despite $T_1^{PCr}$ all show a strong dependency on $f_{off}$. However, this can be neglected since $f_{off}$ is estimated accurately. Note that $f_{off}$ is normalized by the spectral resolution of 60 Hz. The $k_{CK}$ ME is independent of the MEs of $T_2^{PCr}$, $T_1^{ATP}$ and $f_{off}$. However, ME of $k_{CK}$ is negatively associated with the MEs of $T_1^{PCr}$, Cr, and $f_{B1}$. Note that a robust estimation is given for Cr and $T_1^{PCr}$ in previous estimations.

**Figure 5** examines the cost function and linearity approximation, on which the interpolation part of the estimation is based on. For $k^{0} = k_{CK}$ the cost function is zero and thus minimal. The function of $T_{1(PCr)}^{E}$ and $T_{1(ATP)}^{E}$ over $k_{CK}^{F}$ can be approximated by a linear function. A small bias is introduced due to non-linearity.

*III.3 In vivo data*

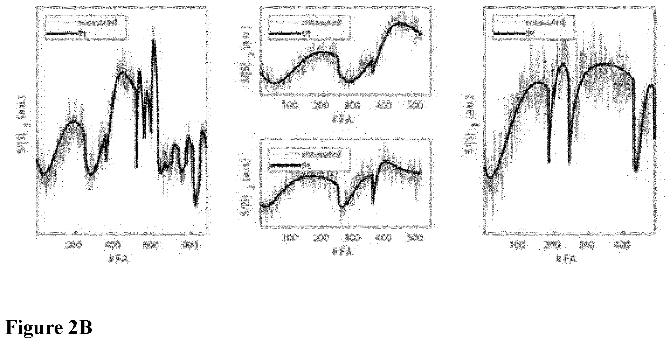

**Figure 2A** shows the grouped spectra of part A and part B of the sequence. The PCr and $\gamma$ATP signal are extracted and for the matching procedure. An exemplary matching procedure for $k_{CK}^{F.Y} = 0.3$ is shown in **Figure 2B,** displaying the parts used of the measurement with their matching dictionary entries for each iteration step.

The SNR (signal-to-noise ratio) of the measured patterns of PCr and $\gamma$ATP, mean and STD of the estimated parameters, $T_1^{PCr}$, $T_1^{ATP}$, $T_2^{PCr}$ and $k_{CK}$ for different number of averages were determined. The acquisition time includes one dummy scan. For comparison, the EBIT estimations are also determined. The IP-$^{31}$P-MRF estimates compare generally well to EBIT, with only $T_1^{PCr}$ estimated 0.5 s lower. The SNR of PCr signal and $\gamma$ATP are comparable despite the lower concentration of $\gamma$ATP due to the shorter $T_1$ relaxation time. The STD of $T_1^{PCr}$, $T_1^{ATP}$, $T_2^{PCr}$ and $k_{CK}$ increases for lower number of averages and SNR. The mean estimates remain constant for the IP-$^{31}$P-MRF. The concentration

ratio Cr is more robust against changes in SNR, with steady STD for even low number of averages.

*III.4 Reproducibility comparison*

**Figures 6A** and **6B.** The IP-$^{31}$P-MRF are compared with EBIT over different acquisition times for different parameters as shown in the various panels (a)-(f). For IP-$^{31}$P-MRF the mean of the estimated parameter stays constant over acquisition times, and the STD is converged for acquisition times beyond 10:25 min. The STD is approximately doubled for 2:18 min acquisition time compared to the full-length acquisition. The EBIT method estimates are biased along with an increased STD for shorter acquisition times. In general, the STD is larger for EBIT compared to IP-$^{31}$P-MRF for the same acquisition length. The test-retest results are evaluated by the mean and STD of the CV in percentage for each estimated parameter. The CV for IP-$^{31}$P-MRF stays constant for a reduced acquisition time of 9:17 min compared to full length. Afterwards mean and STD are increasing. The Mean CV does not exceed 20% for $T_1^{PCr}$ and $k_{CK}$ and 10% for $T_1^{ATP}$ and $T_2^{PCr}$. Overall, the mean and STD of $k_{CK}$ and $T_1^{ATP}$ are lower the EBIT for the same acquisition time.

*IV. Discussion*

Effect of $f_{B1}$ on parameter estimation (especially $T_2$ estimation). This bias is dependent on the range of $k_{CK}^F$ values and their values compared to the ground truth. Due to high sensitivity, surface coils are commonly used to acquire $^{31}$P MRS spectra in the human brain. However, their transmit field show a strong inhomogeneity and has to be incorporated in the dictionary. We incorporated additional relaxation parameters, adding up to a total of 7 parameters to estimate. By our knowledge, so far this is the largest parameter set to fit introduced in the MRF framework. To address the problem of creating and fitting large multi-parametric dictionaries, we introduce the IP-$^{31}$P-MRF solving approach, which combines an iterative parameter estimation with small dictionaries and an interpolation approach to converge to a bias free estimation.

References:

[1] Guido Buonincontri, Rolf F. Schulte, Mirco Cosottini, and Michela Tosetti, Spiral MR fingerprinting at 7t with simultaneous b1 estimation, Magnetic resonance imaging 41 (2017), 1-6.
[2] Tsang-Lin Hwang, Peter CM Van Zijl, and Michael Garwood, Asymmetric adiabatic pulses for nh selection, 1999, pp. 173-177.
[3] Dan Ma, Simone Coppo, Yong Chen, Debra F McGivney, Yun Jiang, Shivani Pahwa, Vikas Gulani, and Mark A Griswold, Slice profile and b1 corrections in 2d magnetic resonance fingerprinting, Magnetic resonance in medicine 78 (2017), no. 5, 1781-1789.
[4] Charlie Y Wang, Yuchi Liu, Shuying Huang, Mark A Griswold, Nicole Seiberlich, and Xin Yu, 31P magnetic resonance fingerprinting for rapid quantification of creatine kinase reaction rate in vivo, NMR in biomedicine 30 (2017), no. 12, 1-14.

**Claims**

1.  A method for providing an estimated value ($v_X^E$) for each of N different parameters ($px = [p_1, p_2 ..., p_N]$) that affect an acquired signal evolution obtained during a Magnetic Resonance Fingerprinting (MRF) measurement, wherein N is an integer of $\geq 3$, the method comprising:

    - defining one, two or more of said N parameter as free parameters ($p_X^F$); defining one, two or more of the remaining parameters as non-free parameters; and setting the values of the non-free parameters to a set parameter value ($v_X^S$);
    - obtaining a dictionary of simulated signal evolutions by using values for said free parameters and said set parameter values ($v_X^S$);
    - obtaining an estimated value ($v_X^E$) for said free parameters by matching a simulated signal evolution with said acquired signal;
    - optionally, obtaining an estimated value ($v_X^E$) for one or more non-free parameters by calculation from available data, preferably including data associated with the estimated value obtained for one or more free parameters, and,
    - repeating the steps of obtaining a dictionary and obtaining an estimated value iteratively, wherein the value of one or more parameters, which were previously free parameters are set to the estimated values ($v_X^E$) obtained by said matching, wherein one or more of said other parameters that were previously non-free parameters, if they cannot be obtained by said calculation, are defined as actual free parameters ($p_X^F$), and wherein repetition is conducted until an estimated value is obtained for all said parameters.

2. The method of claim 1, which comprises, when defining said one or more free parameters:
defining a plurality of $Z(p_X^F)$ successive values ($v_X^{F.Y} = v_X^{F.1}, v_X^{F.2}, ... , v_X^{F.Z}$; $Y = [1, .... Z(p_X^F)]$) of an assumed value range ($v_X^{F.1} - v_X^{F.Z}$) independently for each of said free parameters, said assumed value range being preferably selected so as to encompass an assumed value ($v_X^A$), said estimated value ($v_X^E$) to be determined and/or a true value of said parameter, wherein Z is an integer $\geq 2$ determined independently for each of said free parameter ($p_X^F$).

3. The method of claim 2, wherein obtaining said dictionary of simulated signal evolutions comprises using the set parameter values ($v_X^S$) for the non-free parameters, and, for the free parameters ($p_X^F$), creating at least one simulated signal evolution for each of said plurality of successive parameter values ($v_X^{F.Y}$).

4. The method of any one of the preceding claims, wherein obtaining an estimated value ($v_X^E$) by matching comprises:

   - matching an acquired signal evolution with said simulated signal evolutions of said dictionary,

      - selecting a best match between said acquired signal and said simulated signal evolutions of said dictionary, and,
      - determining an estimated value ($v_X^E$) for said free parameters ($p_X^F$), wherein said estimated value ($v_X^E$) is the value of the free parameter ($p_X^{F.Y}$) used for the simulated signal evolution corresponding to said best match.

5. The method of any one of claims 2-4, wherein repeating the steps of obtaining a dictionary and obtaining an estimated value iteratively comprises:

   (1) using said estimated value ($v_X^E$) for at least one of said previously free parameters ($p_X^F$) and/or, if applicable, said calculated parameters, as a set value of the parameter, and selecting one or more actual free parameters among the previously non-free parameters;
   (2) defining a plurality of $Z(p_X^F)$ successive values for the actual free parameters as defined in claim 2;
   (3) obtaining said dictionary of simulated signal evolutions and obtaining an estimated value ($v_X^E$) for said actual free parameters by matching.

6. The method of any one of the preceding claims, wherein setting the parameters values of one, two or more other parameters to a set parameter value ($v_X^S$) comprises:

   (i) in as far as available, using an estimated value ($v_X^E$), obtained previously by matching or, if applicable, by calculation, as a set parameter value ($v_X^S$),
   (ii) in as far as an estimated value ($v_X^E$) under (i) is not available, using an assumed value ($v_X^A$) as said set parameter value ($v_X^S$) of the corresponding parameter, which assumed value ($v_X^A$) may be selected from likely values, literature values or previously reported and/or previously determined values for the corresponding parameter, and,
   (iii) if the parameter is a global parameter, setting the value to a corresponding, predetermined successive start value ($v_G^{S.T}$) of said global parameter.

7. The method of any one of the preceding claims, wherein defining said free and non-free parameters comprises:

   a) splitting said N parameters $p_1$-$p_N$ in n groups, such that each group contains one or more different parameters;
   b) selecting one group of said n groups, wherein the parameters in that one group are free parameters ($p_X^F$) and the estimated values ($v_X^E$) of at least one of said free parameters is to be determined by matching with simulated signal evolutions; and wherein repeating the steps of obtaining said dictionaries and obtaining an estimated value iteratively comprises:
   c) selecting another group of said n groups, wherein said other group comprises parameters for which an estimated parameter value ($v_X^E$) has not yet been determined, defining one, more or all parameters of said other group as free parameters ($p_X^F$), and obtaining estimated values ($v_X^E$) for the free parameters of said other group.

8. The method of any one of the preceding claims, which further comprises, once an estimated value ($v_X^E$) is obtained for each parameter, repeating the method while using, for one, several or all N parameters ($px$), the obtained estimated value ($v_X^E$) or, if available, a final estimated value ($v_X^{E+}$), as said set value ($v_X^S$), instead of an assumed value ($v_X^A$).

9. The method of any one of the preceding claims, comprising selecting J global parameter ($p_G$) among said N parameters ($px = p_1, p_2, ... , p_N$), wherein J is an integer of 1 or larger and smaller than N, wherein said one or more global parameter is a parameter having one or more properties selected from the group consisting of:

   - a parameter having an influence on the estimated value ($v_X^E$) of all other parameters;
   - a parameter having the largest impact on the estimated value ($v_X^E$) of one or more other parameters;
   - a parameter having an influence on the estimated value ($v_X^E$) of the largest number of the other parameters;
   - a parameter on which one or more other parameters, preferably relaxation parameters, can be approximated to depend in a functional, for example a linear manner.

10. The method of any one of the preceding claims, comprising:

   defining a particular parameter ($px$) as a global parameter ($p_G$) and defining a plurality of $Z(p_G^S)$ successive start values ($v_G^{S.T} = v_G^{S.1}, v_G^{S.2}, ... , v_G^{S.Z}; T = [1, .... Z(p_G^S)]$) of a global value range ($v_G^{S.1} - v_G^{S.Z}$) of said global parameter;
   defining one or more non-global parameter ($px$) as a free parameter ($p_X^F$); and,
   obtaining an estimated value ($v_X^E$) for said one or more non-global, free parameter for each of said $Z(p_G^S)$ successive start values of said global parameter, preferably in accordance with any one of the preceding claims.

11. The method of any one of claims 9 to 10, comprising obtaining an estimated value ($v_G^{E.T}$) of the global parameter ($p_G$) for each successive start value ($v_G^{S.T} = v_G^{S.1}, v_G^{S.2}, ... , v_G^{S.Z}; Z = [1, .... Z(p_G^S)]$) of a global value range ($v_G^{S.1} - v_G^{S.Z}$) of said global parameter ($p_G$), preferably by:

   - setting the values of said non-global parameters ($p_X^F$) to the estimated values ($v_X^{E.T}$) of said parameter ($p_X^F$) obtained with a particular successive start value ($v_G^{S.T}$) of said global parameter; and,
   - using said global parameter as a free parameter ($p_G^F$) so as to obtain simulated signal evolutions that allow to obtain, by matching, an estimate ($v_G^{E.T}$) of said global parameter that is associated with said particular successive start value ($v_G^{S.T}$) of said global parameter.

12. The method of claim 11, wherein using said global parameter as a free parameter ($p_G^F$) comprises defining a plurality of successive values ($v_G^{F.Y} = v_G^{F.1}, v_G^{F.2}, ... , v_G^{F.Z}; Y = [1, ... Zp_G^F]$) within an assumed value range ($v_G^{F.1} - v_G^{F.Z}$) of said global, free parameter, wherein $Zp_G^F$ is preferably larger than $Zp_G^S$ and/or wherein the average numeric distance between successive values is preferably shorter in the assumed value range ($v_G^{F.1} - V_G^{F.Z}$), where the global parameter is a free parameter, than in said global value range ($v_G^{S.1} - v_G^{S.Z}$) of the global parameter.

13. The method of any one of claims 9-11, which comprises determining a final estimated value ($v_G^{E+}$) of said global parameter ($p_G$), comprising:

   - defining a cost function $d = f(v_G^{S.T}, v_G^{E.T})$, in which an estimated value ($v_G^{E.T}$) of the global parameter ($p_G$) is mathematically related with the successive start value ($v_G^{S.T}$) of the global parameter that was used for obtaining said estimated value ($v_G^{E.T}$) of the global parameter ($p_G$);
   - determining the final estimated value ($v_G^{E+}$) of said global parameter by minimizing the cost function.

14. The method of claim 13, wherein said cost function $d$ is obtained by an artificial neural network (ANN) approach that establishes a correlation between different points $P_T(v_G^{E.T}, v_G^{S.T})$ and/or by interpolation, preferably by interpolating the points $P_T(v_G^{S.T}; v_G^{E.T} - v_G^{S.T})$.

15. The method of any one of the preceding claims, further comprising determining a final estimated value ($v_{X \backslash G}^{E+}$) of one or more of said parameters ($px$), preferably other than said global parameter ($p_G$), by:

   - defining a function $E^+ = f(v_{X \backslash G}^E, v_G^{S.T})$ in which the estimated value ($v_{X \backslash G}^E$) of said other, non-global parameter ($p_{X \backslash G}^E$) depends on the corresponding successive start value ($v_G^{S.T}$) of a global parameter ($p_G$) from which said estimated parameter ($v_{X \backslash G}^E$) value was obtained;

- determining a final estimated value ($v_G^{E+}$) for said global parameter ($p_G$), for example according to any one of claims 13-14;
- defining the final estimated value ($v_{X\backslash G}^{E+}$) of said one or more other parameter ($p_{X\backslash G}$) as the value of said parameter in said function $E^+$ where the global parameter ($p_G$) has the final estimated value ($v_G^{E+}$).

16. The method of any one of claims 13-15, wherein said cost function d is obtained by interpolating the points $P_T(v_G^{S.T}, v_G^{E.T}-v_G^{S.T})$, and/or wherein said function $E^+$ is obtained by interpolating the points $P(v_G^{S.T}, v_{X\backslash G}^{E})$.

17. The method of any one of claims 9-16, wherein a dependency of one or more non-global or other parameters from said global parameter, and/or an influence of said global parameter on one or more non-global parameters, for example a correlative relationship, can be found by mathematical methods such as interpolation or artificial neural network (ANN) approaches.

18. The method of any one of claims 9-17, wherein a dependency of one or more non-global or other parameters from said global parameter, and/or an influence of said global parameter on one or more non-global parameters, for example a correlative relationship, can be established between estimated values ($v_X^{E.T}$) of a plurality of estimated values of one of said one or more non-global parameters when depending on the successive start values ($v_G^{S.T}$) of said global parameter.

19. The method of any one of claims 9-18, wherein one or more non-global parameters are considered as mathematically related with, for example correlated with and/or dependent on said global parameter by way of a linear functional relationship and/or wherein an interpolation or artificial neuronal network approach is conducted in view of obtaining a functional relationship.

20. The method of any one of the preceding claims, wherein said N different parameters comprise one or more parameters selected from the group consisting of:

- one or more relaxation parameters, for example selected from the group consisting of $T_1$ (longitudinal relaxation time of relaxation in dimension z), $T_2$ (transversal relaxation time of relaxation in plane xy, "natural" $T_2$), $T_2^*$ ("effective" $T_2$);
- chemical exchange rates, such as $k_{CK}$ (the chemical exchange rate of the phosphate between $\gamma$ATP and PCr);
- concentration ratios, for example Cr (the concentration ratio between PCr and $\gamma$ATP);
- parameters related to the magnetic fields ($B_1$, $B_0$), such as $\gamma B_1^+$ (transmitted $B_1$ field inhomogeneities), $\gamma B_1^-$ (received field sensitivity), $f_{off}$ (the mean off resonance of the $B_0$ distribution).

**Figure 1A**

**Figure 1B**

**Figure 1C**

**Figure 2A**

**Figure 2B**

**6**

Repeat for n=5 different assumed
$k^0_{CK} = [0.2, 0.3, 0.35, 0.4, 0.5]\ s^{-1}$

**2**

**1**

**4**

**5**

**7**

| inhomogeneity fit | $T_1^{PCr}$ fit $\quad$ $T_1^{ATP}$ fit $\quad$ $C_r$ fit | $k_{CK}$ fit | interpolate parameters |
|---|---|---|---|

**3**

- Set assumed $T^0_1$
- Set assumed $k^0_{CK,n}$
- Set assumed concentration ratio $C^0_r$
- Fit for $f_{B1}$ and $f_{off}$

- Set estimated $\hat{f}_{B1}$ and $\hat{f}_{off}$
- Assumed $k^0_{CK,n}$
- Fit for $\hat{T}_1$
- determining $C^0_r$

- Set estimeated $\hat{f}_{B1}$ and $\hat{f}_{off}$
- Set $\hat{T}_1$ and $\hat{c}_r$
- Fit $\hat{k}_{CK}$

- $\min(|\ k^0_{CK}\text{-}k_{CK,fit}|)$
- Estimate $\tilde{k}_{CK}$
- Estimate $\tilde{T}_1(k_{CK})$

**Figure 3B**

**Figure 4**

**Figure 5**

**Figure 6A**

Figure 6B

Figure 3A

# EP 4 266 075 A1

# EUROPEAN SEARCH REPORT

Application Number

EP 22 16 9601

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | US 10 492 710 B2 (UNIV CASE WESTERN RESERVE [US]) 3 December 2019 (2019-12-03) | 1-6,9 | INV. G01R33/56 G01R33/561 |
| A | * column 7, line 38 - line 51 * * column 8, line 35 - line 50 * ----- | 7,8, 10-15 | |
| A | XIE JUN ET AL: "Fast dictionary generation and searching for magnetic resonance fingerprinting", 2017 39TH ANNUAL INTERNATIONAL CONFERENCE OF THE IEEE ENGINEERING IN MEDICINE AND BIOLOGY SOCIETY (EMBC), IEEE, 11 July 2017 (2017-07-11), pages 3256-3259, XP033152728, DOI: 10.1109/EMBC.2017.8037551 [retrieved on 2017-09-13] * the whole document * ----- | 1-15 | |
| A | US 2019/242961 A1 (MEINEKE JAN JAKOB [DE] ET AL) 8 August 2019 (2019-08-08) * the whole document * ----- | 1-15 | |

TECHNICAL FIELDS SEARCHED (IPC)

G01R

The present search report has been drawn up for all claims

| Place of search | Date of completion of the search | Examiner |
|---|---|---|
| Munich | 16 January 2023 | Raguin, Guy |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 22 16 9601

This annex lists the patent family members relating to the patent documents cited in the above-mentioned European search report.
The members are as contained in the European Patent Office EDP file on
The European Patent Office is in no way liable for these particulars which are merely given for the purpose of information.

16-01-2023

| Patent document cited in search report | | Publication date | Patent family member(s) | | | Publication date |
|---|---|---|---|---|---|---|
| US 10492710 | B2 | 03-12-2019 | NONE | | | |
| US 2019242961 | A1 | 08-08-2019 | CN | 109791186 | A | 21-05-2019 |
| | | | DE | 112017005080 | T5 | 11-07-2019 |
| | | | US | 2019242961 | A1 | 08-08-2019 |
| | | | WO | 2018065233 | A1 | 12-04-2018 |

EPO FORM P0459

For more details about this annex : see Official Journal of the European Patent Office, No. 12/82

**EP 4 266 075 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 10416259 B
- US 10492710 B

- US 20150301138 A

### Non-patent literature cited in the description

- **DAN MA et al.** *Nature,* 2013, vol. 495 (7440), 187-192
- **F. BLOCH.** *Nuclear Induction, Phys Rev,* 1946, vol. 70, 460-474
- **WANG et al.** *NMR Biomed.,* 2017, vol. 30, 12
- **GUIDO BUONINCONTRI ; ROLF F. SCHULTE ; MIRCO COSOTTINI ; MICHELA TOSETTI.** Spiral MR fingerprinting at 7t with simultaneous b1 estimation. *Magnetic resonance imaging,* 2017, vol. 41, 1-6
- **TSANG-LIN HWANG ; PETER CM VAN ZIJL ; MICHAEL GARWOOD.** *Asymmetric adiabatic pulses for nh selection,* 1999, 173-177

- **DAN MA ; SIMONE COPPO ; YONG CHEN ; DEBRA F MCGIVNEY ; YUN JIANG ; SHIVANI PAHWA ; VIKAS GULANI ; MARK A GRISWOLD.** Slice profile and b1 corrections in 2d magnetic resonance fingerprinting. *Magnetic resonance in medicine,* 2017, vol. 78 (5), 1781-1789
- **CHARLIE Y WANG ; YUCHI LIU ; SHUYING HUANG ; MARK A GRISWOLD ; NICOLE SEIBERLICH ; XIN YU.** 31P magnetic resonance fingerprinting for rapid quantification of creatine kinase reaction rate in vivo. *NMR in biomedicine,* 2017, vol. 30 (12), 1-14